(19) Europäisches Patentamt
European Patent Office
Office européen des brevets

(11) EP 1 577 088 B1

(12) EUROPEAN PATENT SPECIFICATION

(45) Date of publication and mention of the grant of the patent:
**08.10.2008 Bulletin 2008/41**

(51) Int Cl.:
***B41C 1/10*** *(2006.01)*

(21) Application number: **05005861.9**

(22) Date of filing: **17.03.2005**

(54) **Method of making a planographic printing plate**

Herstellungsverfahren einer Flachdruckplatte

Méthode de fabrication d'une plaque lithographique

(84) Designated Contracting States:
**AT BE BG CH CY CZ DE DK EE ES FI FR GB GR HU IE IS IT LI LT LU MC NL PL PT RO SE SI SK TR**

(30) Priority: **19.03.2004 JP 2004081601**

(43) Date of publication of application:
**21.09.2005 Bulletin 2005/38**

(73) Proprietor: **FUJIFILM Corporation**
**Minato-ku**
**Tokyo (JP)**

(72) Inventor: **Goto, Takahiro**
**c/o Fuji Photo Film Co., Ltd.**
**Shizuoka-ken (JP)**

(74) Representative: **HOFFMANN EITLE**
**Patent- und Rechtsanwälte**
**Arabellastrasse 4**
**81925 München (DE)**

(56) References cited:
**EP-A- 1 241 002**
**US-A1- 2003 124 460**
**US-A1- 2004 013 968**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 577 088 B1

Printed by Jouve, 75001 PARIS (FR)

## Description

Field of the Invention

The present invention relates to the use of monoalcohols and monoketones as antigelling agents in developing solutions for use in the production of a negative-type planographic printing plate from a precursor thereof e.g. when using a method that allows direct drawing and high-speed processing with an infrared laser beam.

Description of the Related Art

Pre-sensitive Plates (PS plates) having an oleophilic photosensitive resin layer on a hydrophilic support have hitherto widely been used as planographic printing plate precursors. Desirable PS printing plates have been produced commonly by performing mask exposure (surface exposure) through a lith film and dissolving, and thus removing the non-image portions. In recent years, digital technology wherein image information is processed, stored, and outputted electronically by computers is becoming more popular. Accordingly, a greater number of new image-output methods compatible with such digital technology have been commercialized. As a result, there is an urgent need for the "computer to plate (CTP) technology" that allows direct production of printing plates by scanning highly-directable light such as a laser beam according to digitalized image information without the use of lith film, and thus for planographic printing plate precursors that are compatible with the CTP technology.

A planographic printing plate precursor wherein an oleophilic photosensitive resin layer (hereinafter, also referred to as a photosensitive layer) containing a photosensitive compound that can generate an active species such as a free radical, Bronsted acid, or the like by laser exposure formed on a hydrophilic support was proposed as a planographic printing plate precursor compatible with such scanning exposure, and has been already commercialized. It is possible to obtain negative-type planographic printing plates by: scanning the planographic printing plate precursor with a laser, according to digital information to generate such active species, which causes the exposed portions of the photosensitive layer to physically or chemically change and to be insolubilized; and developing the scanned planographic printing plate. In particular, a planographic printing plate precursor which is a possible candidate for the desirable printing plate superior in printing properties is one having, on a hydrophilic support, a photopolymerizabale photosensitive layer containing a photopolymerization initiator which has a superior sensitization speed, an addition-polymerizable ethylenic unsaturated compound, and a binder polymer soluble in an alkaline developing solution, and optionally having an oxygen-blocking protective layer. Such a printing plate precursor is superior in productivity and can be developed by a simple method and provides a printing plate superior in resolution and ink-receiving properties.

Alkali-developable organic polymers such as methacrylic acid copolymers, acrylic acid copolymers, itaconic acid copolymers, crotonic acid copolymers, maleic acid copolymers, and partially esterified maleic acid copolymers have hitherto been used as the binder polymer for the photosensitive layer (e.g., Japanese Patent Application Laid-Open (JP-A) No. 59-44615, Japanese Patent Application Publication (JP-B) Nos. 54-34327, 58-12577, and 54-25957, JP-A Nos. 54-92723, 59-53836, 59-71048, and 2002-40652). However, in conventional planographic printing plates having a photosensitive layer containing such a binder polymer, the hardness of the image portions, which should be completely cured, is often insufficiently cured and thus the plates exposed are generally heated to secure sufficient curing before processing in the developing step.

The heating is effective in re-reacting radicals remaining after the exposing step with the component(s) of the photosensitive material. However, the heating causes image unevenness, in particular dot unevenness, since it is difficult to heat the entire surface of the plate uniformly. When the heating temperature is 100°C or more, it becomes more difficult to heat the plate uniformly and thus the above problem becomes remarkable. The heating temperature in a conventional preheating step is in the range of 100 to 150°C, causing dot unevenness and deterioration of printing durability during continuous processing.

When the curing is insufficient, the developing solution penetrates into the image portions in an greater amount in the developing step, consequently leading to damage of the photosensitive layer and deterioration of printing durability. On measure to avoid this problem, i.e., to suppress the penetration of the developing solution into image portions is to shorten the processing time in the developing step by raising the traveling speed of plates. However, in the plate heated before development, image unevenness caused by non-uniformity of the heating often occurs, and this tendency is more apparent in image portions for which higher resolution is required such as dots and thin lines.

Therefore, there is an increasing need for a planographic printing plate precursor that suppresses generation of image unevenness and deterioration of printing durability in dot regions during development, and allows formation of images having uniform, superior image quality over the entire surface of the plate.

Forming a protective layer containing a water-soluble polymer on the photosensitive layer is known to accelerate the curing reaction of the photosensitive layer. Such planographic printing plates are preferably washed with water to remove the protective layer before development, but it is desirable that the number of processing steps is decreased to

accelerate the speed of development. When such plates are developed continuously for an extended period of time or developed without water washing, the developing solution often gelates due to the water-soluble polymer derived from the protective layer, causing deterioration in development efficiency and generating stains in the non-image portions. There is also a need for improvement in this regard.

Also, there is a need for a method of making a planographic printing plate from a precursor thereof having a protective layer on a photosensitive layer on which precursor thereof image can be formed with an infrared laser, and which provides a planographic printing plate having superior image quality and printing durability without generation of stains in the non-image portion even after continuous processing for an extended period of time.

SUMMARY OF THE INVENTION

The inventors of the invention have found that it is possible to satisfy the above needs by adding a monoalcohol or monoketone compound to the developing solution used during development substantially without heating and water-washing steps.

The invention provides a new use of monoalcohols and monoketones, as defined in claim 1. The developing solution is used in a method of making a planographic printing plate, involving: exposing to light having a wavelength of 750 to 1,400 nm a planographic printing plate precursor having on a support a photosensitive layer containing an infrared absorbent, a polymerization initiator, a polymerizable compound, and a binder polymer, and a protective layer in that order; and developing a planographic printing plate exposed in a developing solution substantially without heating and washing, wherein the developing solution contains an antigelling agent selected from the group consisting of monoalcohol compounds and monoketone compounds.

The action of the invention is not clear, but seems as follows. In the method of making a planographic printing plate, the plate exposed is developed directly without heating. Therefore, the local fluctuation in the photosensitive-layer curing reaction caused by non-uniform heating is suppressed, and thus images, even images such as dots and thin lines, having superior uniformness and sharpness are formed, and the deterioration in printing durability of dot or thin line portions is suppressed,

Moreover, in the plate-making method, the antigelling agent such as a monoalcohol compound or a monoketone compound in the developing solution may suppress gelation of the developing solution, which is caused by the protective layer component(s) dissolved in the developing solution when the plates are developed continuously for an extended period of time, and consequently prevent development inhibition and stain in the non-image portions.

Further, since the plate-making method does not need heating and washing, which are possible destabilizing factors, images having superior uniformness and sharpness are formed, and the deterioration in printing durability of dot or thin line portions is suppressed even at a high developing speed of 1.25 m/min or more.

BRIEF DESCRIPTION OF THE DRAWWINGS

Figure 1 is a schematic diagram illustrating an example of DRM interference wave measuring device for measurement of the dissolving behavior of each photosensitive layer.

Figure 2 is a schematic diagram illustrating an example of a method of determining electrostatic capacitance used for evaluation of the permeability of a developing solution into a photosensitive layer.

DETAILED DESCRIPTION OF THE INVENTION

Hereinafter, the method of making a planographic printing plate will be described in detail.

In the method of making a planographic printing plate, a planographic printing plate precursor having a support, a photosensitive layer containing an infrared absorbent, a polymerization initiator, a polymerizable compound, and a binder polymer, and a protective layer in that order is exposed to light having a wavelength of 750 nm to 1,400 nm and then developed in a developing solution substantially without heating and washing. Here, the developing solution contains an antigelling agent selected from the group consisting of monoalcohol compounds and monoketone compounds. First, the planographic printing plate precursor used in the plate-making method will be described in detail.

<Planographic printing plate precursor>

The planographic printing plate precursor has a support, a photosensitive layer containing an infrared absorbent, a polymerization initiator, a polymerizable compound, and a binder polymer, and a protective layer in that order. The precursor may further have any other layer(s), which is formed according to needed, such as an intermediate layer and

a backcoat layer.

Each of the components of the planographic printing plate precursor will be described below.

[Photosensitive layer]

The photosensitive layer of the planographic printing plate precursor is a negative-type polymerizable photosensitive layer containing an infrared absorbent, a polymerization initiator, a polymerizable compound (also called addition-polymerizable compound), and a binder polymer as essential components, and may contain additionally a coloring agent and any other components as needed.

The negative-type polymerizable photosensitive layer is sensitive to infrared light and thus to light emitted by an infrared laser, which is useful for CTP. The infrared absorbent is highly sensitive to light emitted by an infrared laser and electronically excited by irradiation (exposure) of the infrared laser. The electron transfer, energy transfer, and/or heat generation (light-heat conversion) due to the infrared absorbent electronically excited act on the polymerization initiator contained in the photosensitive layer, and cause it to chemically change and to generate a free radical.

Examples of mechanism for generating a radical include: (1) heat generated in light-heat conversion by the infrared absorbent causes thermal decomposition of the polymerization initiator described below (e.g., a sulfonium salt) to generate a free radical; (2) an excited electron generated by the infrared absorbent moves to the polymerization initiator (e.g., an activated halogen compound) and the initiator then generates a free radical; and (3) an electron is pulled out of the polymerization initiator (e.g., a borate compound) by the excited infrared absorbent, generating a free radical. The generated radical causes a polymerization reaction of the polymerizable compound and the exposed portions are then cured to form image portions.

The planographic printing plate precursor is particularly suitable for plate making wherein an image is directly formed on the precursor with an infrared laser beam having a wavelength of 750 nm to 1,400 nm, and has an image-forming ability higher than that of conventional planographic printing plate precursors, since the photosensitive layer of the precursor used in the invention contains an infrared absorbent.

Hereinafter, each component of the photosensitive layer of the planographic printing plate precursor used in the invention will be described.

[Infrared absorbent)

The photosensitive layer of the planographic printing plate precursor contains an infrared absorbent for the purpose of attaining energy transfer (electron transfer) and light-heat conversion.

The infrared absorbent is highly sensitive to light emitted by an infrared laser and electronically excited by irradiation (exposure) of the infrared laser, and is useful for the electron transfer, energy transfer, and/or heat generation (light-heat conversion) due to the infrared absorbent electronically excited acting on the polymerization initiator described later, and efficiently causing the polymerization initiator to chemically change and to generate a free radical.

The infrared absorbent used in the invention is preferably a dye or pigment having an absorption maximum at a wavelength of 750 nm to 1,400 nm.

Commercially available dyes and known dyes described in literature, for example, in "Dye Handbook" (edited by Socity of Synthetic Organic Chemistry and published in 1970) may be used as the dye. Typical examples thereof include azo dyes, metal complex salt azo dyes, pyrazolone azo dyes, naphthoquinone dyes, anthraquinone dyes, phthalocyanine dyes, carbonium dyes, quinonimine dyes, methine dyes, cyanine dyes, squalelium dyes, pyrylium salts, and metal thiolate complexes.

The dye is preferably a cyanine dye described in JP-A Nos. 58-125246, 59-84356, or 60-78787; a methine dye described in JP-A Nos. 58-173696, 58-181690, or 58-194595; a naphthoquinone dye described in JP-A Nos. 58-112793, 58-224793, 59-48187, 59-73996, 60-52940, or 60-63744; a squalelium dye described in JP-A No. 58-112792; and/or a cyanine dye described in U.K. Patent No. 434,875.

In addition, preferably used are infrared-absorbing sensitizers described in U.S. Patent No. 5,156,938; substituted arylbenzo(thio)pyrylium salts described in U.S. Patent No. 3,881,924; trimethine thiapyrylium salts described in JP-A No. 57-142645 (U.S. Patent No. 4,327,169); pyrylium compounds described in JP-A No. 58-181051, 58-220143, 59-41363, 59-84248, 59-84249, 59-146063, and 59-146061; cyanine dyes described in JP-A No. 59-216146, pentamethine thiopyrylium salts described in U.S. Patent No. 4,283,475; and pyrylium compounds disclosed in JP-B Nos. 5-13514 and 5-19702. Other preferable examples of the dyes include near infrared-absorbing dyes represented by Formulae (I) and (II) in U.S. Patent No. 4,756,993.

Still other preferable examples of the infrared ray-absorbing dyes used in the invention include the following particular indolenine cyanine dyes disclosed in Japanese Patent Application Nos. 2001-6326 and 2001-237840.

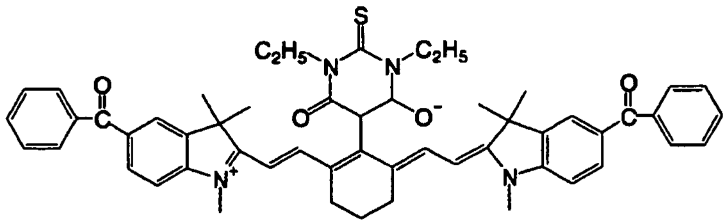

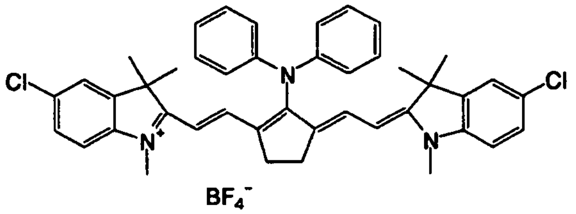

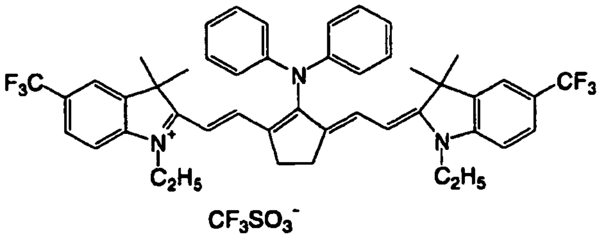

Among these dyes, particularly preferable are cyanine dyes, squalelium dyes, pyrylium salts, nickel thiolate complexes, and indolenine cyanine dyes. Cyanine dyes and indolenine cyanine dyes are more preferable, and particularly preferable are the cyanine dyes represented by the following Formula (a).

Formula (a)

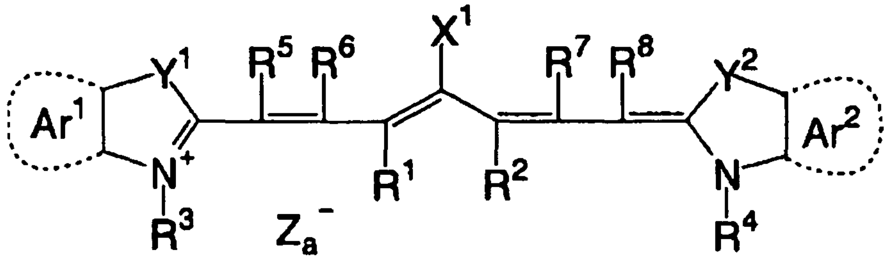

In Formula (a), $X^1$ represents a hydrogen atom, a halogen atom, - $NPh_2$, $X^2$-$L^1$, or the following group. $X^2$ represents an oxygen, nitrogen, or sulfur atom; and $L^1$ represents a hydrocarbon group having 1 to 12 carbon atoms, a hetero atom-containing aromatic ring, or a hetero atom-containing hydrocarbon group having 1 to 12 carbon atoms. The hetero atom represents a nitrogen, sulfur, oxygen, halogen, or selenium atom. Xa has the same definition as that of Za described later, and Ra represents a hydrogen atom, or a substituent group selected from an alkyl group, an aryl group, a substituted or unsubstituted amino group, and a halogen atom.

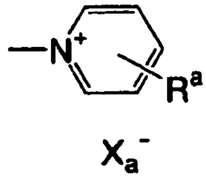

$R^1$ and $R^2$ each independently represent a hydrocarbon group having 1 to 12 carbon atoms. $R^1$ and $R^2$ each are preferably a hydrocarbon group having two or more carbon atoms from the viewpoint of storage stability of a photosensitive layer coating solution. $R^1$ and $R^2$ particularly preferably form a five- or six-membered ring.

$Ar^1$ and $Ar^2$ may be the same as or different from each other and each represent an aromatic hydrocarbon group which may have one or more substituents. Typical examples of the aromatic hydrocarbon group include benzene and naphthalene rings. Typical examples of the substituent(s) include hydrocarbon groups having 12 or less carbon atoms, halogen atoms, and alkoxy groups having 12 or less carbon atoms. $Y^1$ and $Y^2$ may be the same as or different from each other, and each represent a sulfur atom or a dialkylmethylene group having 12 or less carbon atoms. $R^3$ and $R^4$ may be the same as or different from each other and each represent a hydrocarbon group having 20 or less carbon atoms which may have one or more substituents. Typical examples of the substituent(s) include alkoxy groups having 12 or less carbon atoms, carboxyl groups, and a sulfo group. $R^5$, $R^6$, $R^7$ and $R^8$ may be the same as or different from each other, and each represent a hydrogen atom or a hydrocarbon group having 12 or less carbon atoms. The substituent is preferably a hydrogen atom from the viewpoint of availability of raw materials. In addition, $Za^-$ represents a counter anion. However, $Za^-$ does not exist if the cyanine dye represented by Formula (a) has in the structure thereof an anionic substituent, which cancels the electric charge of the quaternary nitrogen atom. The $Za^-$ ion is preferably a halide ion, a perchlorate ion, a tetrafluoroborate ion, a hexafluorophosphate ion, or a sulfonate ion from the viewpoint of storage stability of a photosensitive layer coating solution, and more preferably a perchlorate ion, a hexafluorophosphate ion, or a arylsulfonate ion.

Typical examples of the cyanine dye represented by Formula (a) include those described in paragraph numbers [0017] to [0019] of JP-A No. 2001-133969.

The particular indolenine cyanine dyes disclosed in Japanese Patent Application Nos. 2001-6326 and 2001-237840 described above are particularly preferable.

However, the dyes containing no halide ion as the counter ion are particularly preferable.

Any of commercially available pigments and the pigments described in "Color Index (C.I.) Handbook", "Pigment Handbook" (Edited by Japan Society of pigment technologies, and published in 1977), "Latest Pigment Application Technologies" (CMC Publishing, 1986), and "Printing Ink technologies" (CMC Publishing, 1984) may be used as the pigment.

Examples of the pigment include black pigments, yellow pigments, orange pigments, brown pigments, red pigments, purple pigments, blue pigments, green pigments, fluorescent pigments, metal powder pigments, and polymer-bound dyes. Specific examples thereof include insoluble azo pigments, azolake pigments, condensation azo pigments, chelate azo pigments, phthalocyanine pigments, anthraquinone pigments, perylene and perynone pigments, thioindigo pigments, quinacridone pigments, dioxazine pigments, isoindolinone pigments, quinophtharone pigments, dyed lake pigments, azine pigments, nitroso pigments, nitro pigments, natural pigments, fluorescent pigments, inorganic pigments, and carbon black. Among these pigments, preferable is carbon black.

These pigments may be used without surface treatment but may be surface-treated. Examples of methods for the surface treatment include a method of coating a resin or wax onto the surface of a pigment, a method for attaching a surfactant to a pigment, and a method of binding a reactive substance (e.g., a silane coupling agent, an epoxy compound, and/or a polyisocyanate) to a pigment surface. These surface treatment methods are described in "Properties and Applications of Metal Soaps" (Saiwai Shobo), "Printing Ink technologies" (CMC Publishing, 1984) and "Latest Pigment Application Technologies" (CMC Publishing, 1986).

The diameter of pigment particles is preferably in the range of 0.01 to 10 μm, more preferably in the range of 0.05 to 1 μm, and still more preferably in the range of 0.1 to 1 μm. The pigment particles having a diameter in this preferable range can be dispersed uniformly in the photosensitive layer, allowing production of a uniform photosensitive layer.

Any known dispersion method commonly practiced in the art for production of inks and toners may be used as a method of dispersing the pigment. Examples of a dispersing machine include an ultrasonic dispersing machine, a sand mill, an attritor, a pearl mill, a super mill, a ball mill, an impeller, a disperser, a KD mill, a colloid mill, a dynatron, a three roll mill, and a pressurizing kneader. Such dispersing machines are described in detail in "Latest Pigment Application Technologies" (CMC Publishing, 1986).

When contained in the photosensitive layer of the planographic printing plate precursor, the infrared absorbent may be contained in a layer including other components or in a layer other than that including other components.

The infrared absorbent is preferably contained in an amount of 0.01 to 50%, and preferably 0.1 to 10% by mass with respect to the total solid matter in the photosensitive layer from the viewpoints of uniformity and durability of photosensitive layer. If the absorbent is a dye, the amount is particularly preferably 0.5 to 10% by mass. If the absorbent is a pigment, the amount is particularly preferably 0.1 to 10% by mass.

[Polymerization initiator)

The polymerization initiator has a function to initiate and advance curing reaction of the polymerizable compound described later. Any compound that, when energy is applied thereto, decomposes to generate an active radical, such as thermal decomposition-type radical generators that, when heat is applied thereto, decomposes to generate a free radical, electron transfer-type radical generators that accept the excited electron of an infrared absorbent to generate a free radical, and electron transfer-type radical generators that supply an electron therefrom to an excited infrared absorbent to generate a free radical, may be used as the polymerization initiator. Examples thereof include onium salts, activated halogen compounds, oxime ester compounds, and borate compounds. Two or more of these compounds may be used together. In the invention, the polymerization initiator is preferably an onium salt and more preferably a sulfonium salt.

Examples of the sulfonium salt polymerization initiator include an onium salt represented by the following Formula (1).

Formula (1)

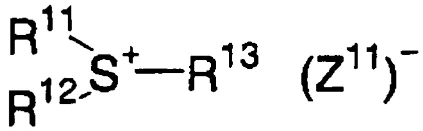

In Formula (1), $R^{11}$, $R^{12}$ and $R^{13}$ may be the same as or different from each other, and each represent a hydrocarbon group having 20 or less carbon atoms which may have one or more substituents. Typical examples of the substituent(s) include halogen atoms, a nitro group, alkyl groups having 12 or less carbon atoms, alkoxy groups having 12 or less carbon atoms, and aryloxy groups having 12 or less carbon atoms. $(Z^{11})^-$ represents a counter ion selected from the group consisting of a halide ion, a perchlorate ion, a tetrafluoroborate ion, a hexafluoro phosphate ion, a carboxyate ion, and a sulfonate ion, and is preferably a perchlorate ion, a hexafluorophosphate ion, a carboxyate ion, or an arylsulfonate ion.

Specific examples of the onium salt represented by Formula (1) ([OS-1] to [OS-12]) are shown below but the invention is not limited by the examples.

[ OS-1 ]

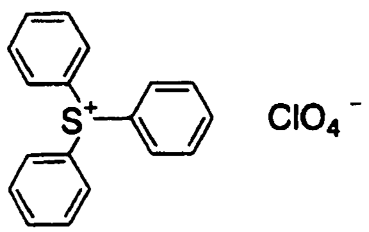

[ OS-2 ]

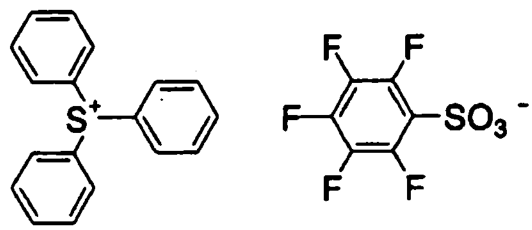

[ OS-3 ]

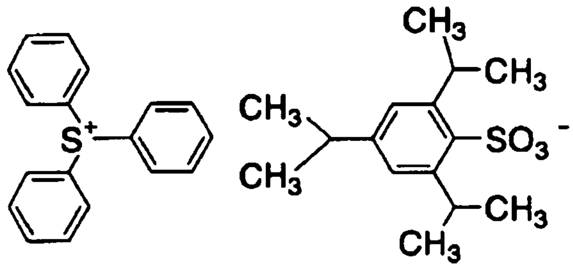

[ OS-4 ]

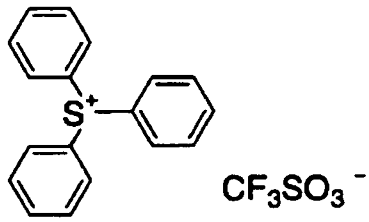

[ OS-5 ]

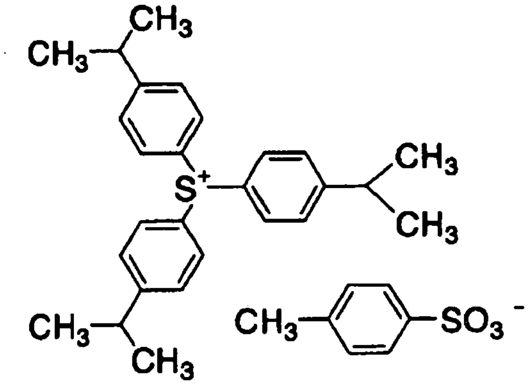

[ OS-6 ]

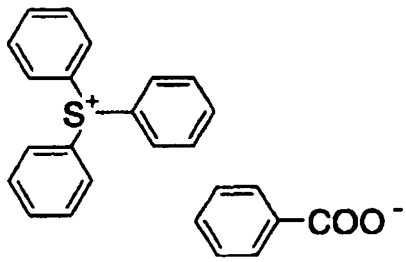

[ OS-7 ]

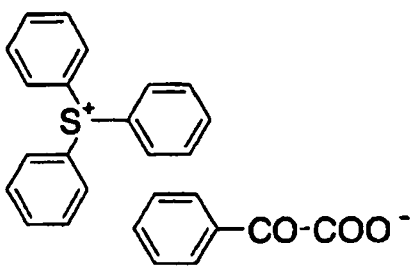

[ OS-8 ]

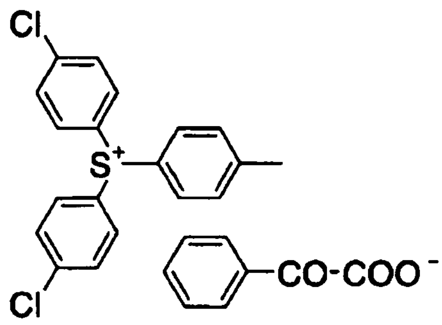

[ OS-9 ]

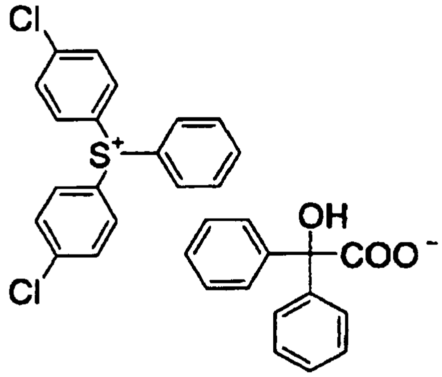

[ OS-10]

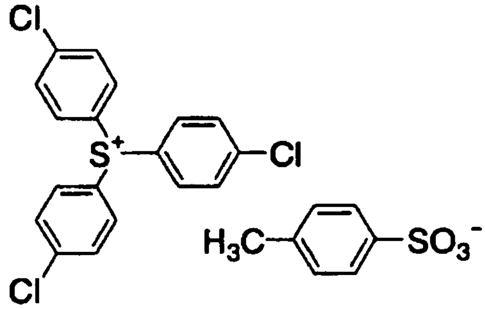

[ OS-11 ]

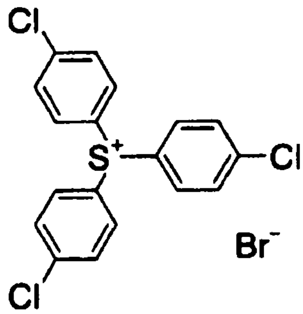

[ OS-12 ]

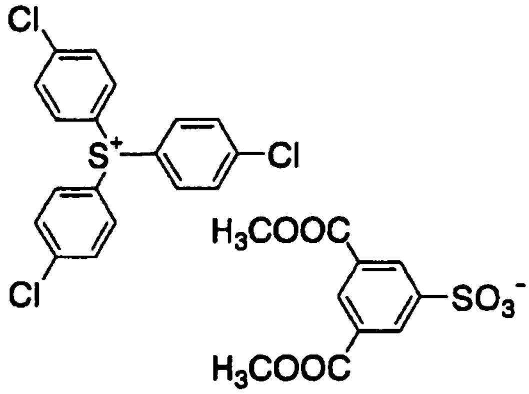

In addition to the compounds described above, a particular aromatic sulfonium salt described in JP-A Nos. 2002-148790, 2002-148790, 2002-350207, and 2002-6482 may also be preferably used.

A polymerization initiator (other radical generator) other than the sulfonium salt polymerization initiator can also be used. Examples of other radical generators include onium salts other than sulfonium salts, triazine compounds having a trihalomethyl group, peroxides, azo polymerization initiators, azide compounds, quinone diazide, activated halogen compounds, oxime ester compounds, and triaryl monoalkyl borate compounds. Among them, an onium salt is preferable, since it is highly sensitive. In addition, a mixture containing a sulfonium salt polymerization initiator as the essential component and one of other polymerization initiators (radical generators) may also be used.

Other onium salt suitable can be an iodonium salt and/or a diazonium salt. The onium salt does not function as an acid generator but functions as an initiator for radical polymerization.

Specific examples of other onium salt for use in the invention include onium salts represented by the following Formulae (2) and (3).

Formula (2)

$$Ar^{21}—I^{+}—Ar^{22}\ (Z^{21})^{-}$$

Formula (3)

$$Ar^{31}-N^{+}\equiv N \quad (Z^{31})^{-}$$

In Formula (2), $Ar^{21}$ and $Ar^{22}$ each independently represent an aryl group having 20 or less carbon atoms which may have one or more substituents. If the aryl group is substituted, typical examples of the substituent(s) include halogen atoms, a nitro group, alkyl groups having 12 or less carbon atoms, alkoxy groups having 12 or less carbon atoms, and aryloxy groups having 12 or less carbon atoms. $(Z^{21})^{-}$ represents a counter ion having the same meaning as that of $(Z^{11})^{-}$.

In Formula (3), $Ar^{31}$ represents an aryl group having 20 or less carbon atoms which may have one or more substituents. Typical examples of the substituent(s) include halogen atoms, a nitro group, alkyl groups having 12 or less carbon atoms, alkoxy groups having 12 or less carbon atoms, aryloxy groups having 12 or less carbon atoms, alkylamino groups having 12 or less carbon atoms, dialkylamino groups having 12 or less carbon atoms, arylamino group having 12 or less carbon atoms, and diarylamino groups having 12 or less carbon atoms. $(Z^{31})^{-}$ represents a counter ion having the same meaning as that of $(Z^{11})^{-}$.

Hereinafter, typical examples of the onium salt represented by Formula (2) ([OI-1] to [OI-10]), and the onium salt represented by Formula (3) ([ON-1] to [ON-5]) are shown below.

[ OI-1 ] 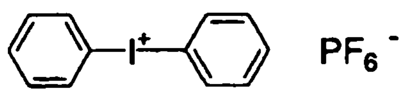

[ OI-2 ] 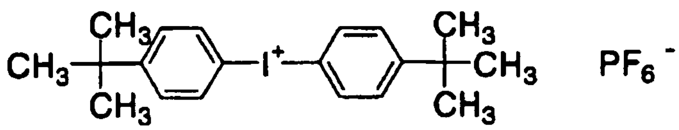

[ OI-3 ] 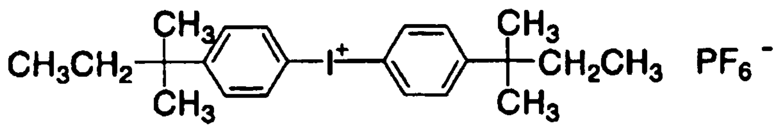

[ OI-4 ] 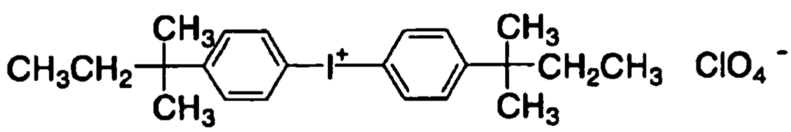

[ 01-5 ]

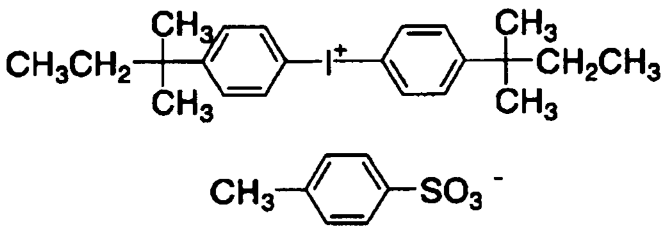

[ 01-6 ]

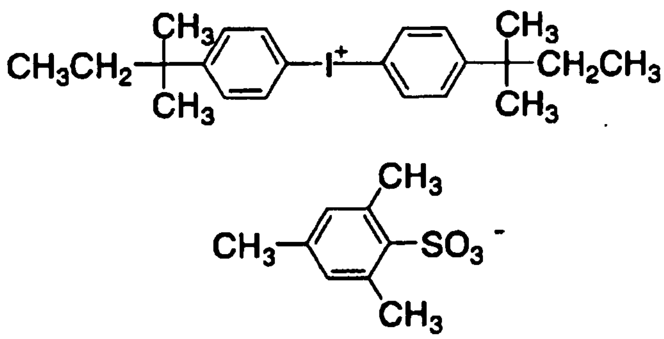

[ 01-7 ]

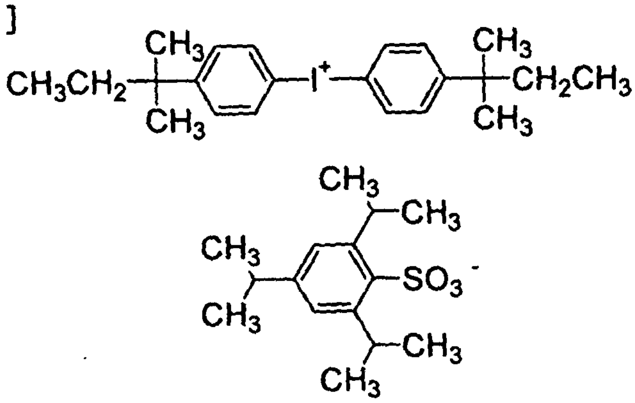

[ 01-8 ]

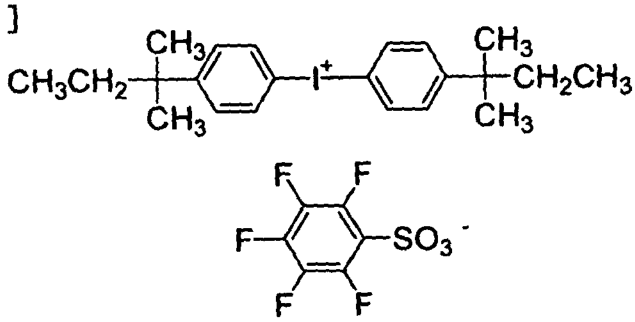

[ OI-9 ]

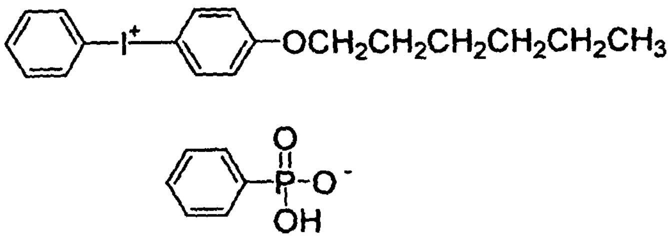

[ OI-10 ]

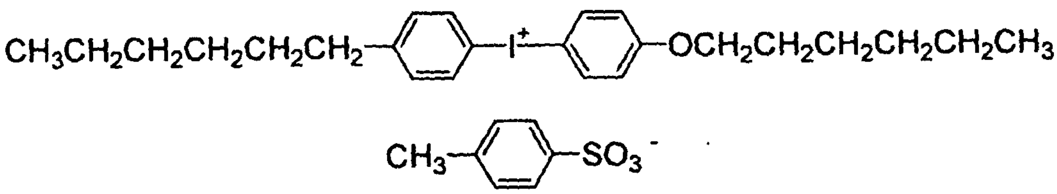

[ ON-1 ]

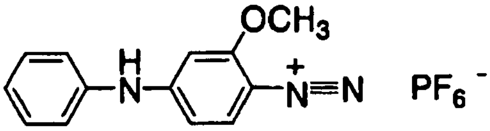

[ ON-2 ]

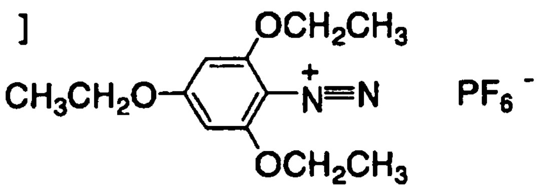

[ ON-3 ]

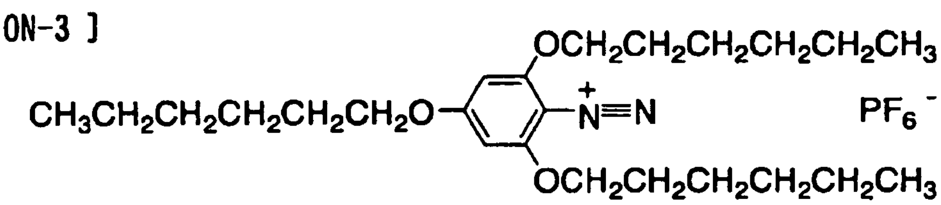

[ ON-4 ]

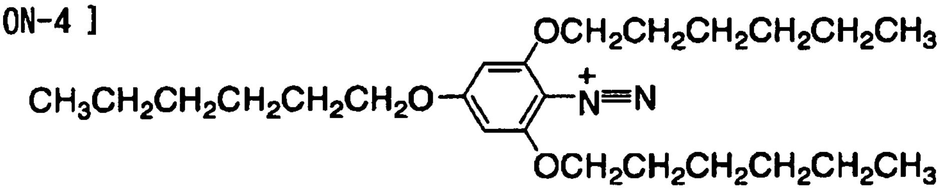

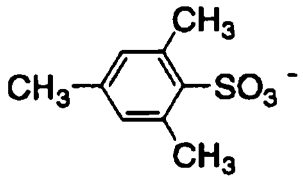

[ ON-5 ]

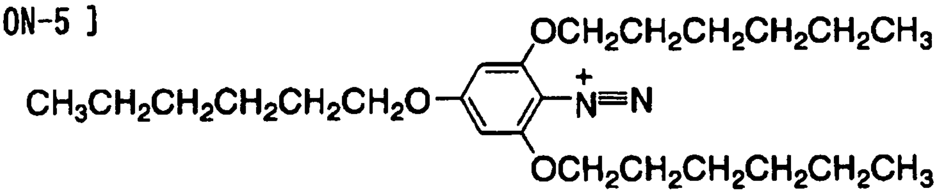

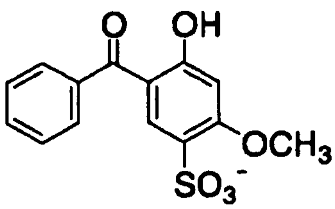

Typical examples of the onium salt as the polymerization initiator (radical generator) include those described in JP-A No. 2001-133696.

The polymerization initiator (radical generator) preferably has a maximum absorption wavelength of 400 nm or less and more preferably 360 nm or less. When the polymerization initiator has an absorption wavelength in the ultraviolet region, it becomes possible to handle the planographic printing plate precursor under white light.

The total amount of the polymerization initiator used is preferably 0.1 to 50%, more preferably 0.5 to 30%, and still more preferably 1 to 20% by mass with respect to the total solid matter in the photosensitive layer from the viewpoints of sensitivity and prevention of stains in non-image portions during printing.

One polymerization initiator may be used, or two or more initiators can be used together. If two or more polymerization initiators are used together, two or more sulfonium salt polymerization initiators may be used without other types of polymerization initiator, or a sulfonium salt polymerization initiator and any other polymerization initiator may be used together.

When a sulfonium salt polymerization initiator and other polymerization initiator are used together, the ratio (mass ratio) of the former and the latter is preferably 100/ 1 to 100/50 and more preferably 100/5 to 100/25.

The polymerization initiator and other components may be contained in the same layer or in different layers.

Use of a high-sensitivity sulfonium salt polymerization initiator which is preferable as the polymerization initiator in the photosensitive layer of the planographic printing plate precursor used in the invention allows efficient progress of the radical polymerization reaction and formation of image portions having extremely high strength. Accordingly, when such a polymerization initiator is used together with a protective layer having a high oxygen-blocking function and described later, a planographic printing plate having high image-portion strength and consequently having further improved printing durability can be made. In addition, the sulfonium salt polymerization initiator, which is superior in storability over time, effectively inhibits undesirable polymerization reaction when the planographic printing plate precursor is stored.

[Polymerizable compound)

The polymerizable compound is an addition-polymerizable compound having at least one ethylenic unsaturated double bond, and is selected from compounds having at least one, and preferably two or more ethylenic unsaturated bonds. These compounds are well known in the art, and any thereof may be used in the invention without restriction. These compounds are present in various chemical forms of monomers, prepolymers such as dimer, trimer and oligomer, and mixtures thereof, and copolymers thereof. Examples of the monomer and copolymer thereof include unsaturated carboxylic acids (e.g., acrylic acid, methacrylic acid, itaconic acid, crotonic acid, isocrotonic acid, and maleic acid) and esters and amides thereof. Other examples thereof include esters of unsaturated carboxylic acids and aliphatic polyhydric alcohol compounds, and amides of unsaturated carboxylic acids and aliphatic polyvalent amine compounds. An adduct of an unsaturated carboxylic acid ester or amide having a nucleophilic substituent such as a hydroxyl group, an amino group, or a mercapto group, and a monofuctional or multifunctional isocyanate or an epoxy compound, and/or a dehydration condensation product from a monofuctional or multifunctional carboxylic acid and a monofuctional or multifunctional isocyanate or an epoxy compound is also preferably used. In addition, preferable are an adduct of an unsaturated carboxylic acid ester or amide having an electrophilic substituent such as an isocyanate group, or an epoxy group, and a monofuctional or multifunctional alcohol, amine, or thiol, and/or a substitution product from an unsaturated carboxylic acid ester or amide having a leaving substituent such as a halogen atom, or a tosyloxy group, and a monofuctional or multifunctional alcohol, amine, or thiol. Further, it is possible to use a compound which is obtained in the same manner as those of the above compounds except that the unsaturated carboxylic acid is replaced with an unsaturated phosphonic acid, styrene, or vinyl ether.

Typical examples of the monomers for the esters of an aliphatic polyvalent alcohol compound and an unsaturated carboxylic acid include acrylic esters, methacrylic esters, itaconic esters, crotonic esters, isocrotonic ester and maleic esters. Examples of the acrylic esters include ethylene glycol diacrylate, triethylene glycol diacrylate, 1,3-butanediol diacrylate, tetramethylene glycol diacrylate, propylene glycol diacrylate, neopentyl glycol diacrylate, trimethylol propane triacrylate, trimethylol propane tri(acrlyloyloxypropyl)ether, trimethylol ethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol haxaacrylate, sorbitol triacrylate, sorbitol tetraacrylate, sorbitol pentaacrylate, sorbitol haxaacrylate, tri(acrlyloyloxyethyl)isocyanurate, and polyester acrylate oligomers.

Examples of the methacrylic esters include tetramethylene glycol dimethacrylate, triethylene glycol dimethacrylate, neopentyl glycol dimethacrylate, trimethylol propane trimethacrylate, trimethylol ethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis(p-(3-methacryloxy-2-hydroxypropoxy)phenyl)dimethyl methane, and bis-(p-(methacryloxyethoxy)phenyl)dimethyl methane.

Examples of the itaconic esters include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

Examples of the crotonic esters include ethylene glycol dicrotonate, tetramethylene glycol dicrotonate, pentaerythritol dicrotonate, and sorbitol tetradicrotonate.

Examples of the isocrotonic esters include ethylene glycol diisocrotonate, pentaerythritol diisocrotonate, and sorbitol tetraisocrotonate.

Examples of the maleic esters include ethylene glycol dimaleate, triethylene glycol dimaleate, pentaerythritol dimaleate, and sorbitol tetramaleate.

Other examples of the esters include esters derived from aliphatic alcohol described in JP-B Nos. 46-27926 and 51-47334, and JP-A No. 57-196231; compounds having an aromatic skeleton described in JP-A Nos. 59-5240, 59-5241, and 2-226149; and compounds having an amino group described in JP-A No. 1-165613. Further, the above ester monomers may also be used as a mixture.

Typical examples of the monomers for the amides of an aliphatic polyvalent amine compound and an unsaturated carboxylic acid include methylene bis-acrylamide, methylene bis-methacrylamide, 1,6-hexamethylene bis-acrylamide, 1,6-hexamethylene bis-methacrylamide, diethylenetriamine trisacrylamide, xylylene bisacrylamide, and xylylene bismethacrylamide. Examples of other preferable amide monomers include compounds having a cyclohexylene structure described in JP-B No. 54-21726.

In addition, urethane addition-polymerizable compounds produced in accordance with addition reaction of an isocyanate and a hydroxyl group-containing compound are also preferable, and typical examples thereof include urethane compounds containing two or more polymerizable vinyl groups described in JP-B No. 48-41708, which are prepared by addition-reacting a vinyl monomer containing a hydroxyl group and represented by the following Formula with a polyisocyanate compound having two or more isocyanate groups in the molecule.

$CH_2=C(Ra)COOCH_2CH(Rb)OH$ Formula

In the formula, Ra and Rb each represent H or $CH_3$.

Additionally, urethane acrylates described in JP-A No. 51-37193, and JP-B Nos. 2-32293 and 2-16765; and urethane compounds having an ethylene oxide main chain described in JP-B Nos. 58-49860, 56-17654, 62-39417, and 62-39418 are also preferable. Further, When the addition-polymerizable compounds having an amino structure or a sulfide structure in the molecule and described in JP-A Nos. 63-277653, 63-260909, and 1-105238 is contained in a photopolymerizable composition, the composition becomes extremely superior in sensitization speed.

Other examples thereof include polyester acrylates described in JP-A No. 48-64183, and JP-B Nos. 49-43191 and 52-30490, multifunctional acrylates and methacrylates obtained by reacting an epoxy resin with a (meth)acrylic acid. Still other examples include particular unsaturated compound described in JP-B Nos. 46-43946, 1-40337, and 1-40336, and vinyl phosphonic acid compounds described in JP-A No. 2-25493. In some cases, compounds having a perfluoroalkyl group and described in JP-A No. 61-22048 are preferably used. In addition, a photo-curable monomer or oligomer described in J. Adhesion Soc. Jpn, vol. 20, No. 7, pp. 300 to 308 (1984) may also be used.

The detail of the structure of the addition-polymerizable compound and a method of using the same, for example, the number of types of such compounds used, and the use amount, may be determined arbitrarily according to desired final performance. For example, the compounds are selected as follows. The compound preferably has many unsaturated groups per molecule, and thus bivalent or higher-valent compounds are preferable from the viewpoint of sensitization speed. In addition, trivalent or higher-valent compounds are preferable to increase strength of image portions, i.e., a cured film. Further, it is effective to use compounds having different valencies and polymerizable groups (e.g., acrylic ester, methacrylic ester, a styrene compound, and/or a vinyl ether compound) to adjust both photosensitivity and strength of the resulting image portions. A high-molecular weight compound or a highly hydrophobic compound has high photosensitive speed and film strength, but may have low development speed and may precipitate in a developing solution. Further, compatibility between the addition-polymerizable compound and other components (e.g., a binder polymer, an initiator, or a coloring agent) and dispersibility thereof in a photosensitive layer are also important factors in selecting or using the addition-polymerizable compound. For example, use of a low-purity compound or a mixture of two or more addition-polymerizable compounds may increase the compatibility.

In addition, a compound having a specific structure may be selected for use in the planographic printing plate precursor used in the invention for the purpose of increasing adhesiveness between the photosensitive layer, and the support or the protective layer.

The content of the addition-polymerizable compound in the photosensitive layer composition is preferably in the range of 5 to 80% and more preferably in the range of 40 to 75% by mass with respect to the solid matter in the photosensitive layer composition from the viewpoints of sensitivity, phase separation, adhesiveness of the photosensitive layer, and the precipitating property thereof in the developing solution.

One addition-polymerizable compound may be used, or two or more polymerizable compounds may be used together. In addition, the structure, composition, and addition amount of the addition-polymerizable compound may be selected arbitrarily, considering the extent of polymerization inhibition by oxygen, resolution, fogging, change in refractive index, and surface adhesiveness. Further, the planographic printing plate precursor may have other layers such as an undercoat or an overcoat.

[Binder polymer)

The binder polymer is contained in the photosensitive layer for the purpose of increasing film-forming property of the layer. Any polymer may be used as such if it improves the film-forming property. Among many polymers, the binder is preferably one having a repeating unit represented by the following Formula (i). Hereinafter, the binder polymer will be referred to as a particular binder polymer and described in detail.

Formula (i)

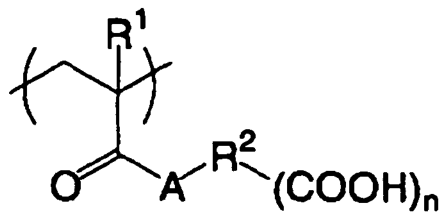

In Formula (i), $R^1$ represents a hydrogen atom or a methyl group; $R^2$ represents a connecting group having two or more atoms selected from the group consisting of a carbon atom, a hydrogen atom, an oxygen atom, a nitrogen atom, and a sulfur atom and having 2 to 82 atoms in total; A represents an oxygen atom or $-NR^3-$, and $R^3$ represents a hydrogen atom or a monovalent hydrocarbon group having 1 to 10 carbon atoms; and n is an integer of 1 to 5.

$R^1$ in Formula (i) represents a hydrogen atom or a methyl group, and is preferably a methyl group.

The connecting group represented by $R^2$ in Formula (i) has two or more atoms selected from the group consisting of a carbon atom, a hydrogen atom, an oxygen atom, a nitrogen atom, and a sulfur atom and has 2 to 82 atoms in total, preferably 2 to 50 atoms, and more preferably 2 to 30 atoms. When the group has a substituent, the total number of atoms of the connecting group includes the number of the atoms of the substituent. More specifically, the number of the atoms of the main chain of the connecting group represented by $R^2$ is preferably 1 to 30, more preferably 3 to 25, and still more preferably 4 to 20, and most preferably 5 to 10. "The main chain of the connecting group" in the invention is an atom or an atomic group used only to connect "A" and the terminal group in Formula (i). If there are multiple routes between them, an atom or atomic group constituting a route having the smallest number of atoms. Accordingly, if the connecting group has a cyclic structure, the number of atom(s) to be counted depends on the connection position of the terminal group (e.g., an ortho-, meta-, or para- position).

More specific examples thereof include substituted and unsubstituted alkylenes, and substituted and unsubstituted arylenes. Further, the connecting group may have a structure wherein two or more of these bivalent groups are bound to each other via an amide bond or ester bond.

Examples of connecting groups having a chain structure include ethylene, and propylene. Such a connecting group can have a structure wherein two or more of these alkylenes are bound to each other via an ester bond.

Among them, the connecting group represented by $R^2$ in Formula (i) is preferably a hydrocarbon group having an alicyclic structure of 3 to 30 carbon atoms and a valency of (n+1). More specific examples thereof include hydrocarbon groups having a valency of (n+1) and prepared by removing (n+1) hydrogen atoms on carbon atoms of compounds having an alicyclic structure and optionally at least one substituent, such as cyclopropane, cyclopentane, cyclohexane, cycloheptane, cyclooctane, cyclodecane, dicyclohexyl, tercyclohexyl, and norbornane. Further, $R^2$ preferably has 3 to 30 carbon atoms, including carbon atoms of the substituent(s).

One or more carbon atoms of the compound having an alicyclic structure may be replaced with one or more hetero atoms selected from a nitrogen atom, an oxygen atom, and a sulfur atom. From the viewpoint of printing durability, $R^2$ is preferably an alicyclic hydrocarbon group having 5 to 30 carbon atoms, containing two or more rings, having a valency of (n+1) and optionally having at least one substituent, such as condensed polycyclic aliphatic hydrocarbon, cross-linked alicyclic hydrocarbon, spiro aliphatic hydrocarbon, and that in which aliphatic hydrocarbon rings are connected to each other directly or via a connecting group. When the compound has at least one substituent, the number of carbon atoms of the compound include those of the at least one substituent.

The connecting group represented by $R^2$ is particularly preferably a group having a main chain thereof having 5 to 10 atoms, and preferably has a chain structure having an ester bond or at least one of the cyclic structures described above.

The substituent(s) that may be introduced to the connecting group represented by $R^2$ can be a monovalent non-metal atomic group excluding hydrogen, and typical examples thereof include halogen atoms (-F, -Br, -Cl, and -I), a hydroxyl group, alkoxy groups, aryloxy groups, a mercapto group, alkylthio groups, arylthio groups, alkyldithio groups, aryldithio groups, an amino group, N-alkylamino groups, N,N-dialkylamino groups, N-arylamino groups, N,N-diarylamino groups, N-alkyl-N-arylamino groups, acyloxy groups, carbamoyloxy groups, N-alkylcarbamoyloxy groups, N-arylcarbamoyloxy groups, N,N-dialkylcarbamoyloxy groups, N,N-diarylcarbamoyloxy groups, N-alkyl-N-arylcarbamoyloxy groups, alkylsulfoxy groups, arylsulfoxy groups, acylthio groups, acylamino groups, N-alkylacylamino groups, N-arylacylamino groups, ureido groups, N'-alkylureido groups, N',N'-dialkylureido groups, N'-arylureido groups, N',N'-diarylureido groups, N'-alkyl-N'-arylureido groups, N-alkylureido groups, N-arylureido groups, N'-alkyl-N-alkylureido groups, N'-alkyl-N-arylureido groups, N',N'-dialkyl-N-alkylureido groups, N',N'-dialkyl-N-arylureido groups, N'-aryl-N-alkylureido groups, N'-aryl-N-arylureido groups, N',N'-diaryl-N-alkylureido groups, N',N'-diaryl-N-arylureido groups, N'-alkyl-N'-aryl-N-alkylureido groups, N'-alkyl-N-aryl-N-arylureido groups, alkoxycarbonylamino groups, aryloxycarbonylamino groups, N-alkyl-N-alkoxycarbonylamino groups, N-alkyl-N-aryloxycarbonylamino groups, N-aryl-N-alkoxycarbonylamino groups, N-aryl-N-aryloxycarbonylamino groups, a formyl group, acyl groups, carboxyl groups and conjugated base groups, alkoxycarbonyl groups, aryloxycarbonyl groups, carbamoyl groups, N-alkylcarbamoyl groups, N,N-dialkylcarbamoyl groups, N-arylcarbamoyl groups, N,N-diarylcarbamoyl groups, N-alkyl-N-arylcarbamoyl groups, alkylsulfinyl groups, arylsulfinyl groups, alkylsulfonyl groups, arylsulfonyl groups, a sulfo group ($-SO_3H$) and conjugated base groups, alkoxysulfonyl groups, aryloxysulfonyl groups, sulfinamoyl groups, N-alkylsulfinamoyl groups, N,N-dialkylsulfinamoyl groups, N-arylsulfinamoyl groups, N,N-diarylsulfinamoyl groups, N-alkyl-N-arylsulfinamoyl groups, sulfamoyl groups, N-alkylsulfamoyl groups, N,N-dialkylsulfamoyl groups, N-arylsulfamoyl groups, N,N-diarylsulfamoyl groups, N-alkyl-N-arylsulfamoyl groups, N-acylsulfamoyl groups and conjugated base groups, N-alkylsulfonylsulfamoyl groups [$-SO_2NHSO_2$(alkyl)] and conjugated base groups, N-arylsulfonylsulfamoyl groups [$-SO_2NHSO_2$(aryl)] and conjugated base groups, N-alkyl-

sulfonylcarbamoyl groups [-$CONHSO_2$(alkyl)] and conjugated base groups, N- arylsulfonylcarbamoyl groups [-$CONHSO_2$(aryl)] and conjugated base groups, alkoxysilyl groups [-Si(Oalkyl)$_3$], aryloxysilyl groups [-Si(Oaryl)$_3$], a hydroxysilyl group [-$Si(OH)_3$] and conjugated base groups, a phosphono group [-$PO_3H_2$] and conjugated base groups, dialkylphosphono groups [-$PO_3$(alkyl)$_2$], diarylphosphono groups [-$PO_3$(aryl)$_2$], alkylarylphosphono group [-$PO_3$(alkyl)(aryl)], monoalkylphosphono groups [-$PO_3H$(alkyl)] and conjugated base groups, monoarylphosphono groups [-$PO_3H$(aryl)] and conjugated base groups, a phosphonooxy group (-$OPO_3H_2$) and conjugated base groups, dialkylphosphonooxy groups [-$OPO_3$(alkyl)$_2$], diarylphosphonooxy groups [-$OPO_3$(aryl)$_2$], alkylarylphosphonooxy groups [-$OPO_3$(alkyl)(aryl)], monoalkylphosphonooxy groups [-$OPO_3H$(alkyl)] and conjugated base groups, monoarylphosphonooxy groups [-$OPO_3H$(aryl)) and conjugated base groups, a cyano group, a nitro group, dialkylboryl groups [-B(alkyl)$_2$], diarylboryl groups [-B(aryl)$_2$], alkylarylboryl groups [-B(alkyl)(aryl)], a dihydroxyboryl group [-$B(OH)_2$] and conjugated base groups, alkylhydroxyboryl groups [-B(alkyl)(OH)] and conjugated base groups, arylhydroxyboryl groups [-B(aryl)(OH)] and conjugated base groups, aryl groups, alkenyl groups, and alkynyl groups.

In the planographic printing plate precursor used in the invention, a substituent having a hydrogen atom which substituent can form a hydrogen bond, particularly a substituent having an acidic group that has an acid dissociation constant (pKa) smaller than that of a carboxylic acid is not preferable, since it tends to decrease printing durability. However, this substituent may be used depending on the design of a photosensitive layer. On the other hand, halogen atoms, hydrophobic substituents such as hydrocarbon groups (alkyl groups, aryl groups, alkenyl groups, and alkynyl groups), alkoxy groups, and aryloxyl groups are preferable, since they tend to improve printing durability. In particular, if the cyclic structure is a monocyclic aliphatic hydrocarbon having six or less members such as cyclopentane or cyclohexane, $R^2$ preferably has such a hydrophobic substituent. Two or more of these substituents may bind to each other or to a substituted hydrocarbon group to form a ring, and may have additionally a substituent thereon.

When A in Formula (i) is $NR^3$-, $R^3$ represents a hydrogen atom or a monovalent hydrocarbon group having 1 to 10 carbon atoms. Examples of the monovalent hydrocarbon groups having 1 to 10 carbon atoms represented by $R^3$ include alkyl groups, aryl groups, alkenyl groups, and alkynyl groups.

Typical examples of the alkyl groups include linear, branched, or cyclic alkyl groups having 1 to 10 carbon atoms such as a methyl group, an ethyl group, a propyl group, a butyl group, a pentyl group, a hexyl group, a heptyl group, an octyl group, a nonyl group, a decyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclopentyl group, a cyclohexyl group, a 1-adamantyl group, and a 2-norbornyl group.

Typical examples of the aryl group include aryl groups having 6 to 10 carbon atoms such as a phenyl group, a naphthyl group, and an indenyl group; and heteroaryl groups having 6 to 10 carbon atoms and containing a hetero atom selected from the group consisting of a nitrogen atom, an oxygen atom and a sulfur atom such as a furyl group, a thienyl group, a pyrrolyl group, a pyridyl group, and a quinolyl group.

Typical examples of the alkenyl group include linear, branched, or cyclic alkenyl groups having 2 to 10 carbon atoms such as a vinyl group, a 1-propenyl group, a 1-butenyl group, a 1-methyl-1-propenyl group, a 1-cyclopentenyl group, and a 1-cyclohexenyl group.

Typical examples of the alkynyl group include alkynyl groups having 2 to 10 carbons such as an ethynyl group, a 1-propynyl group, a 1-butynyl group, and a 1-octynyl group. The substituent(s) which $R^3$ may have is the same as those which $R^2$ may have. The number of carbon atoms of $R^3$ is 1 to 10, including the carbon atoms of the substituent(s).

A in Formula (i) is preferably an oxygen atom or -NH-, since such a compound is easy to produce.

In Formula (i), n is an integer of 1 to 5, and preferably 1 from the viewpoint of printing durability.

Typical examples of the repeating unit represented by Formula (i) are shown below, but the invention is not limited by these examples.

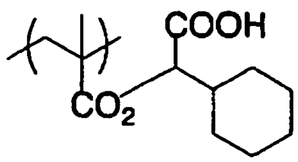

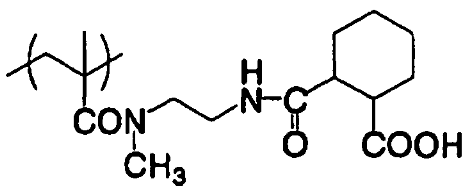

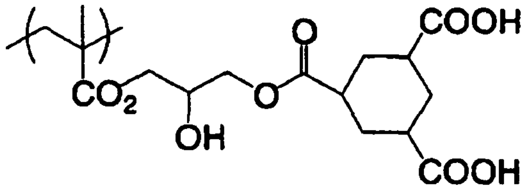

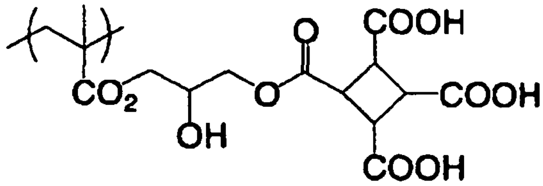

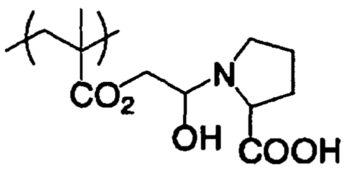

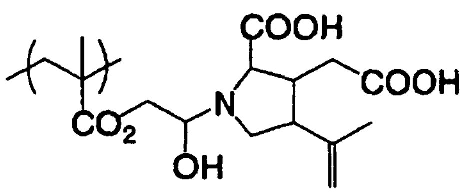

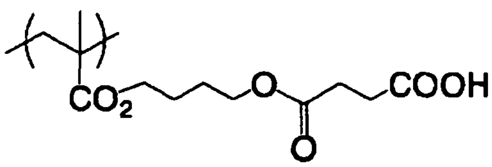

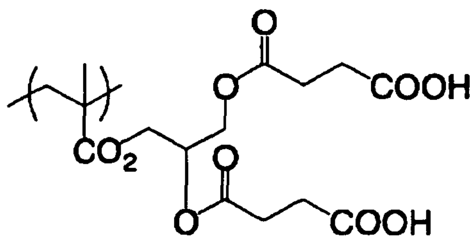

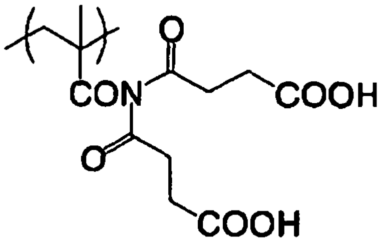

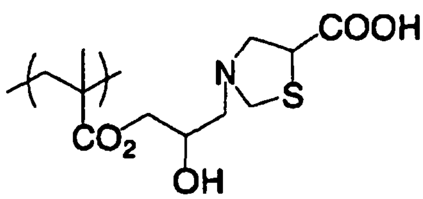

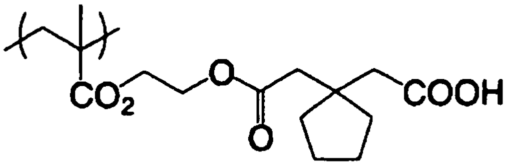

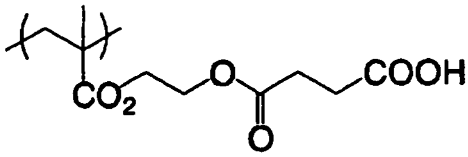

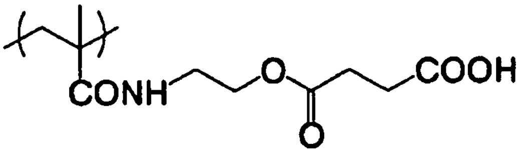

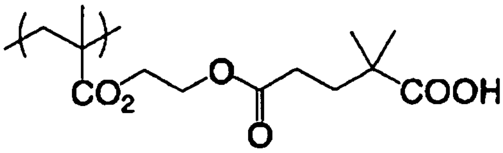

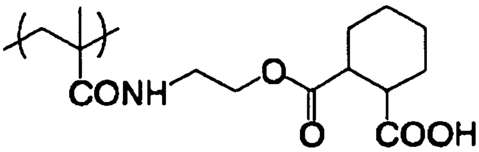

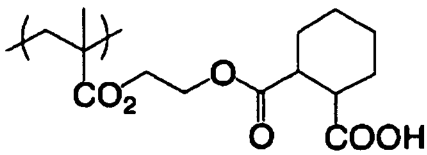

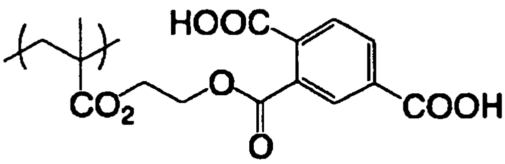

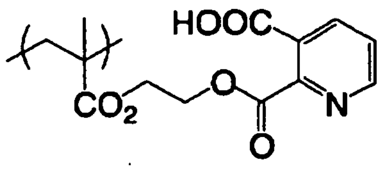

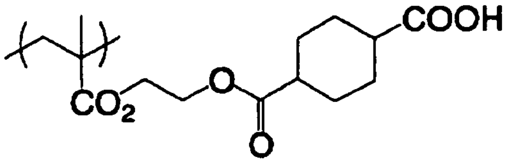

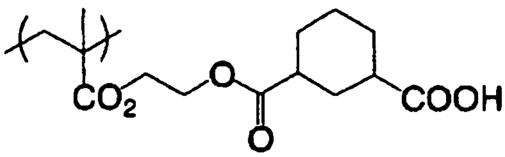

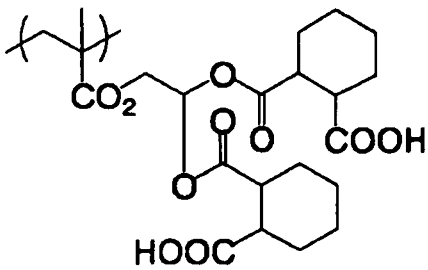

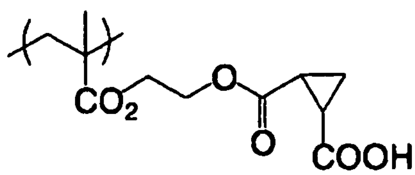

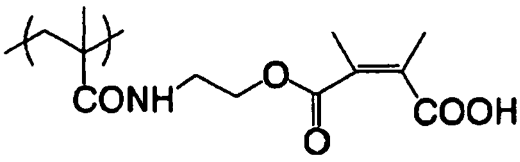

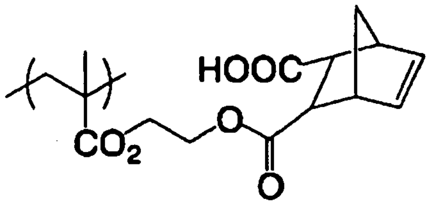

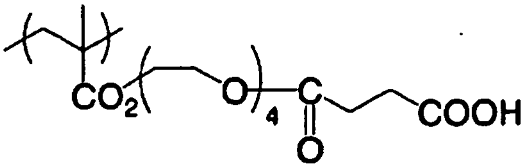

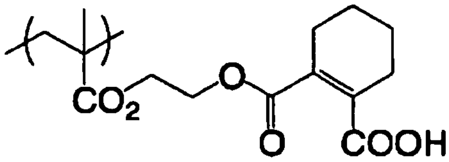

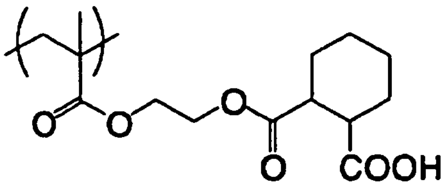

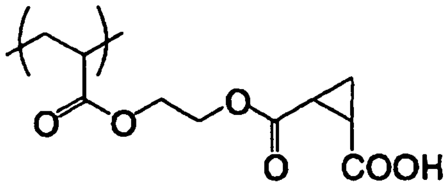

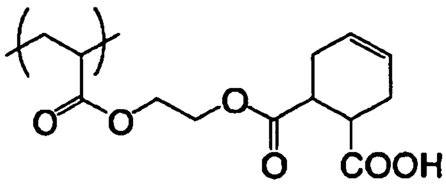

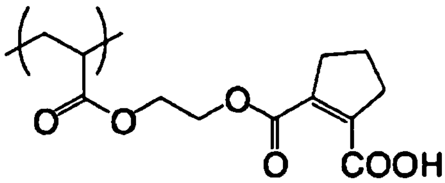

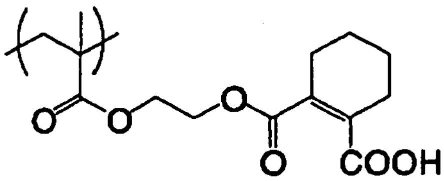

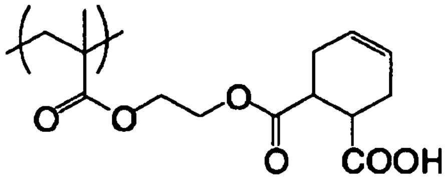

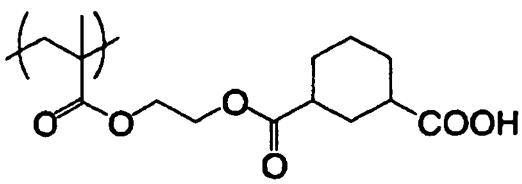

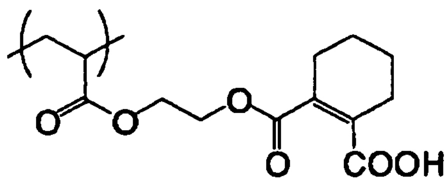

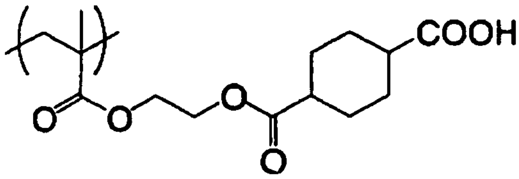

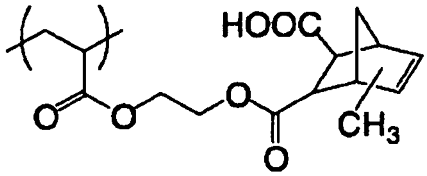

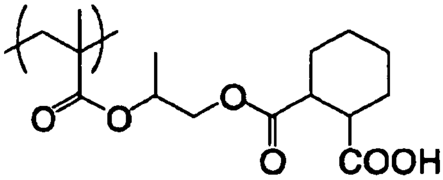

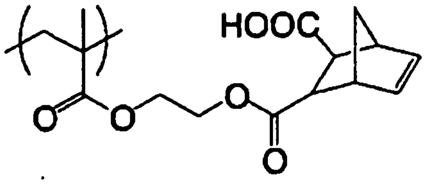

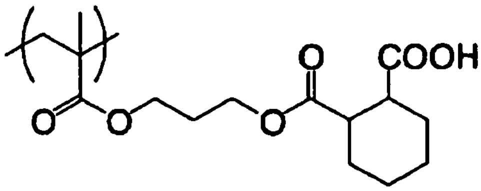

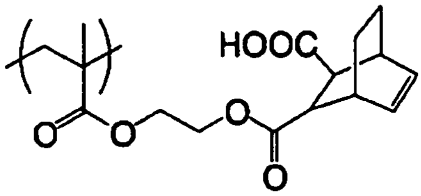

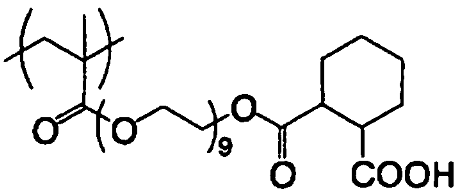

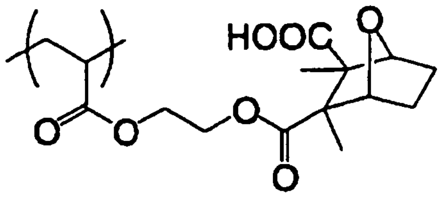

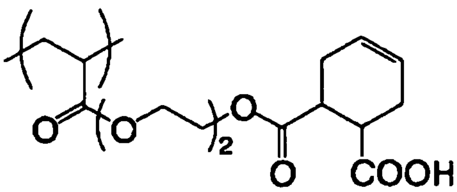

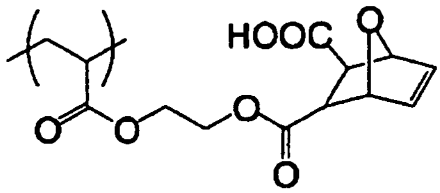

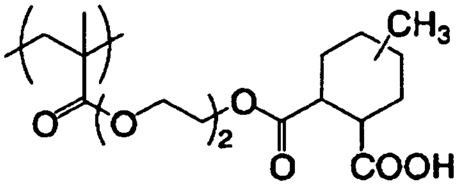

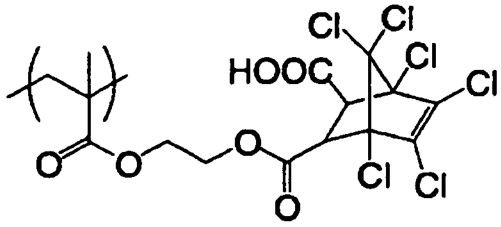

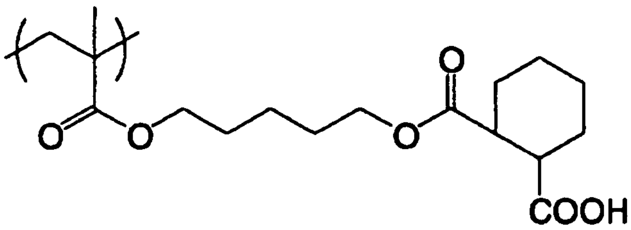

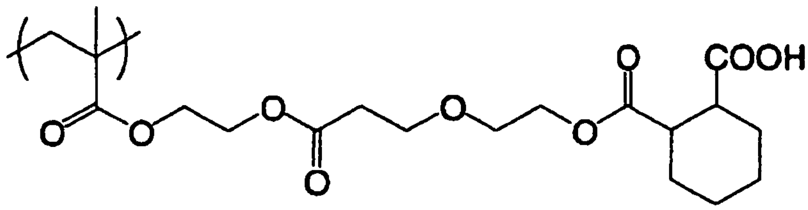

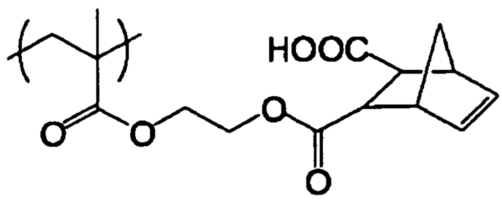

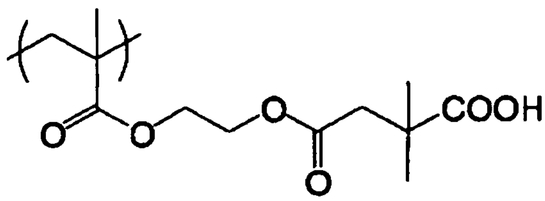

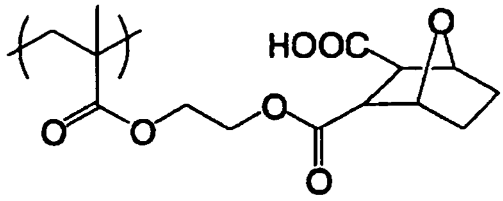

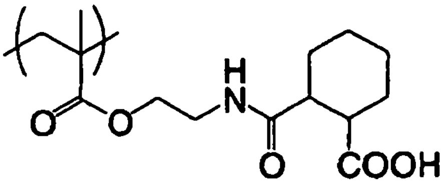

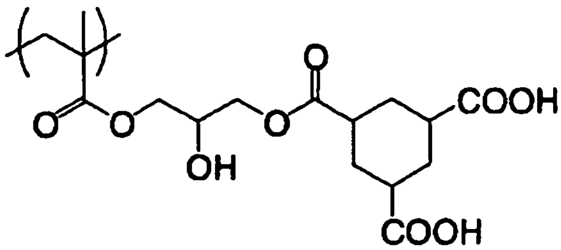

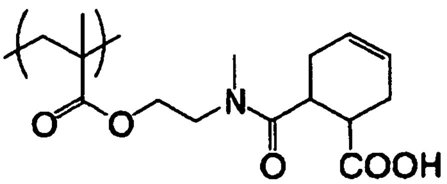

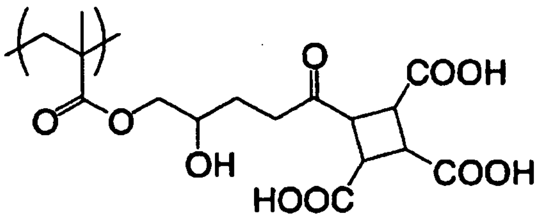

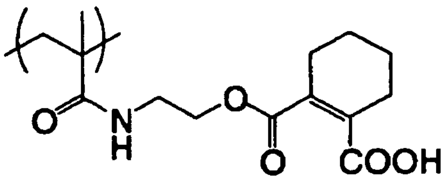

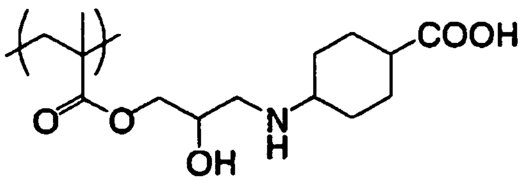

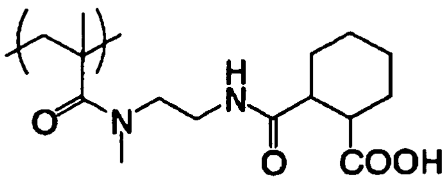

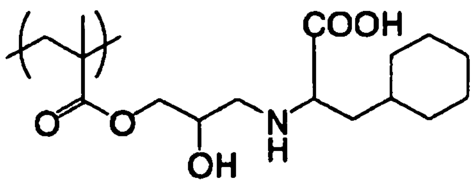

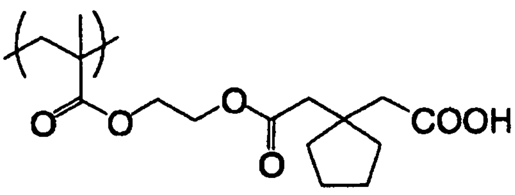

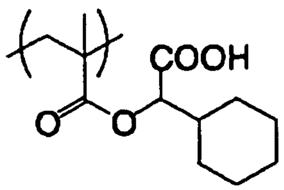

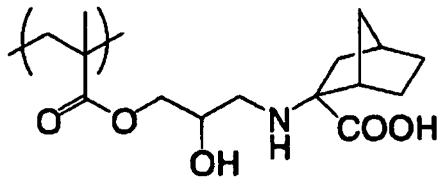

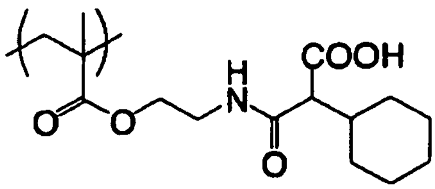

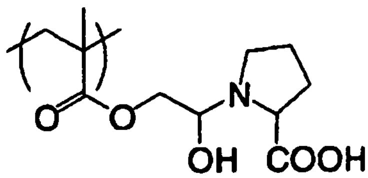

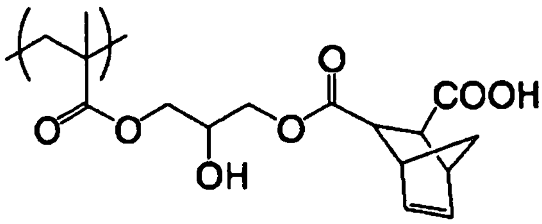

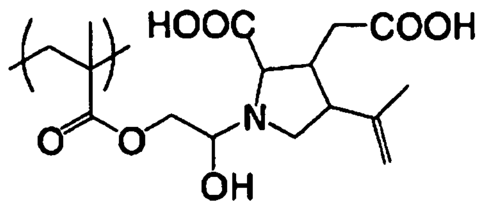

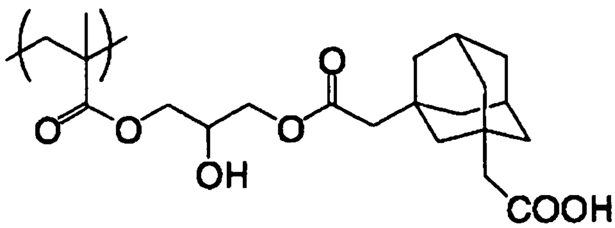

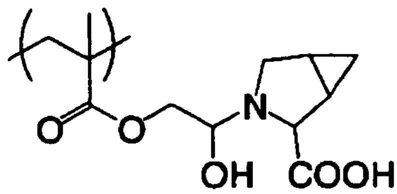

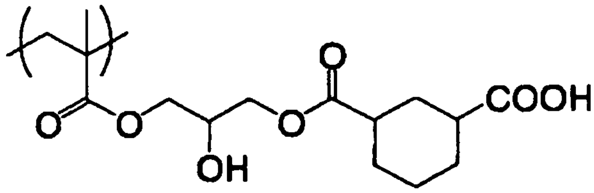

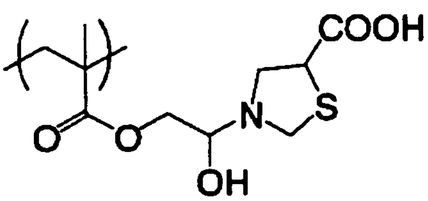

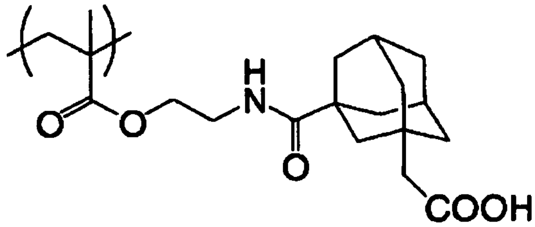

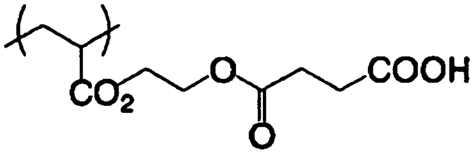

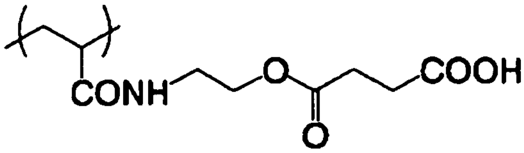

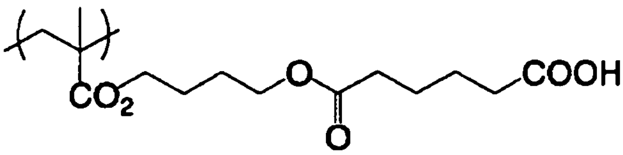

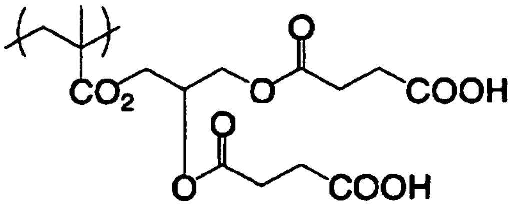

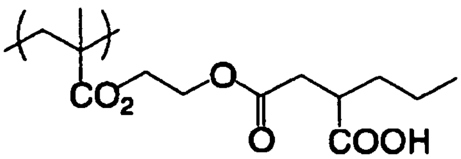

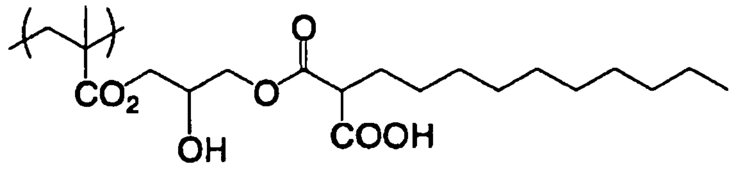

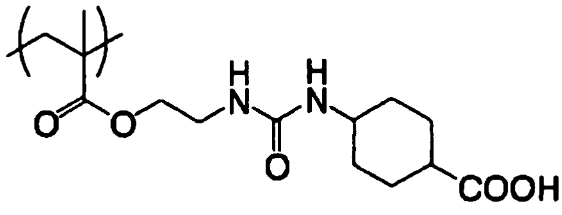

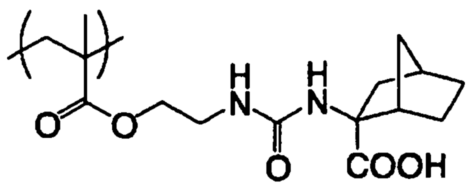

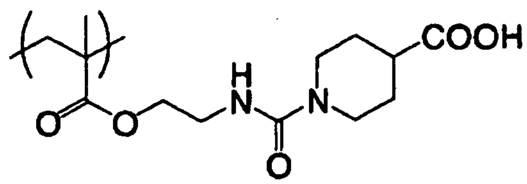

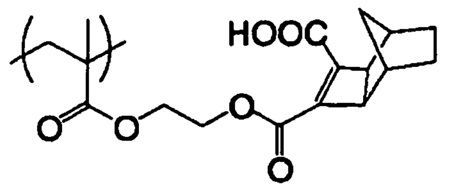

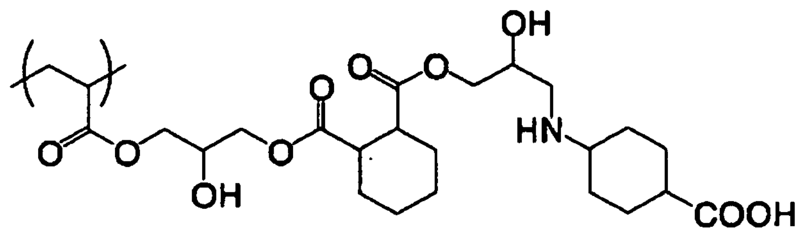

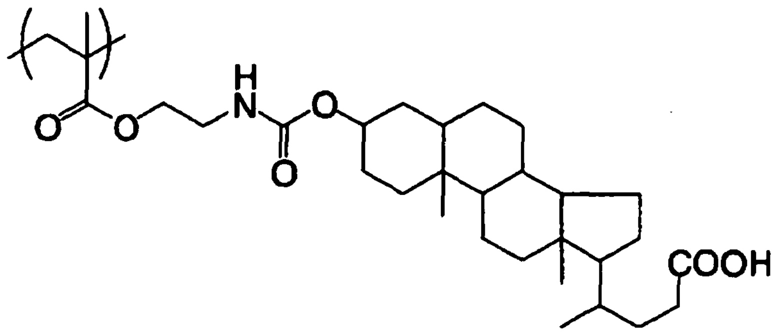

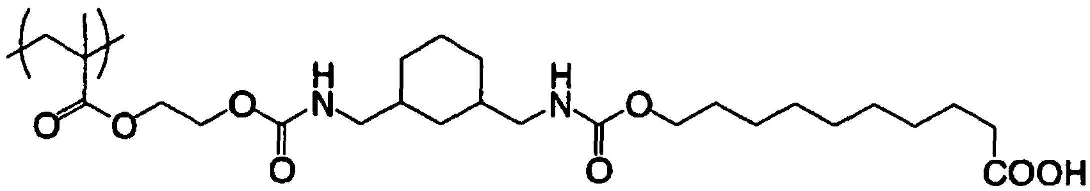

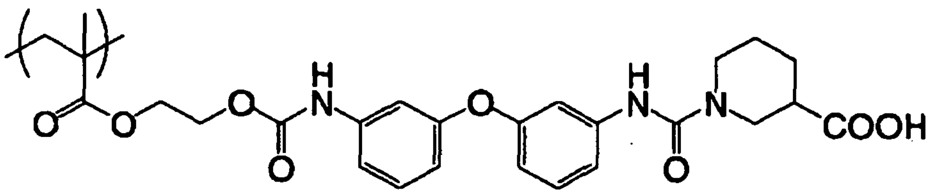

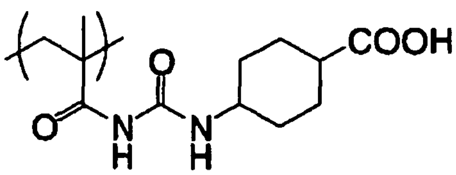

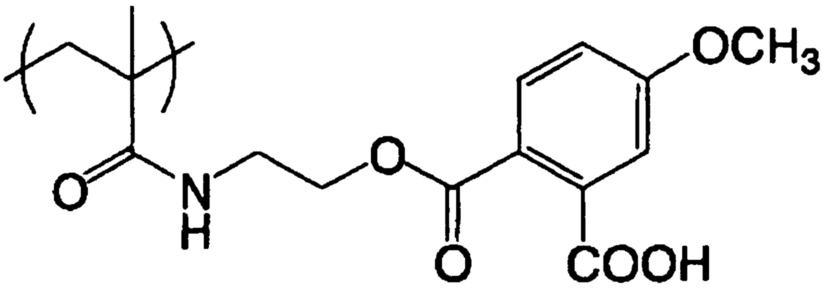

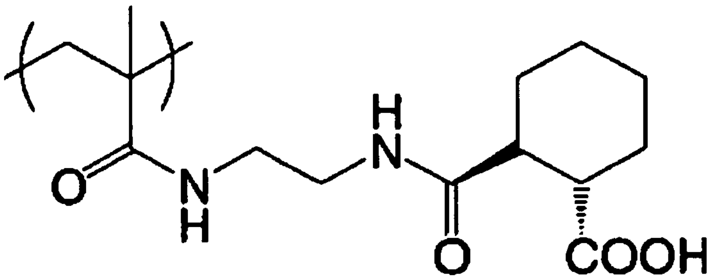

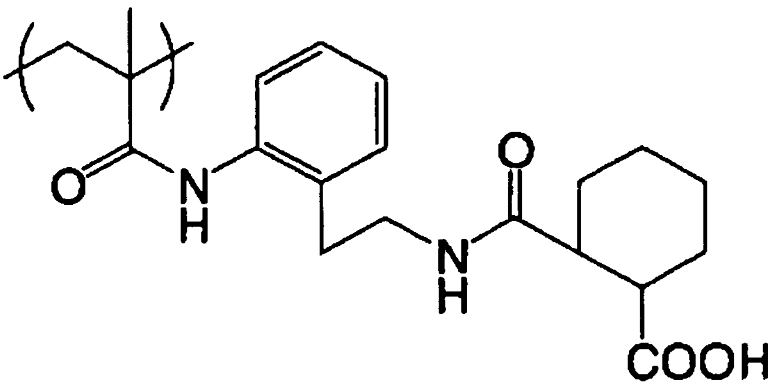

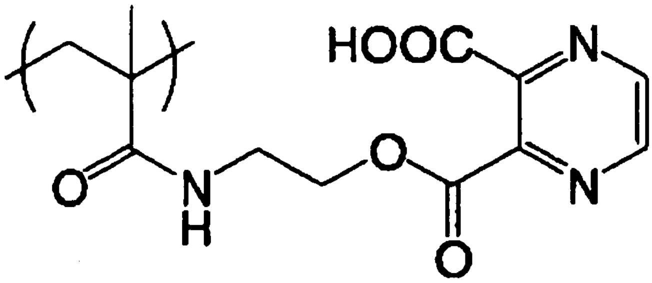

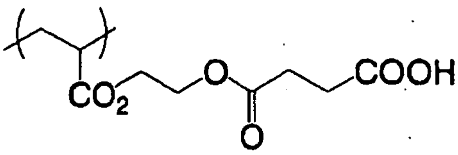

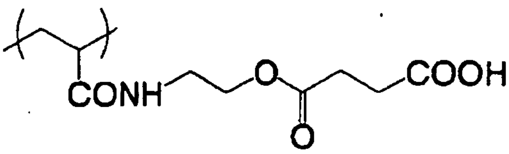

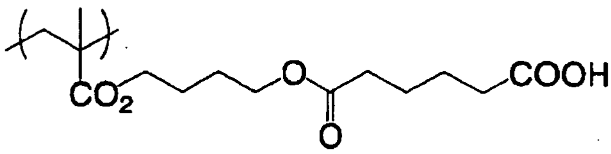

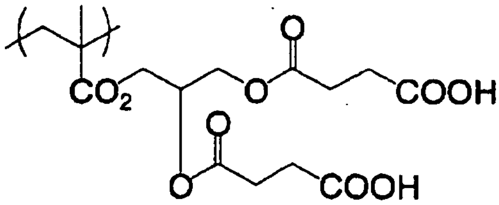

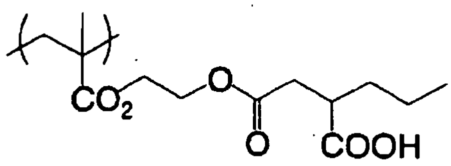

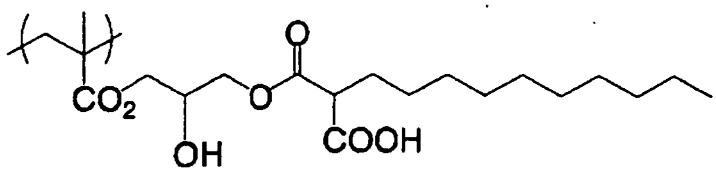

The binder polymer may have one or more of the repeating units represented by Formula (i). The particular binder polymer may be a polymer consisting only of the repeating unit(s) represented by Formula (i), but is usually a copolymer in which at least one repeating unit described above is copolymerized with one or more other copolymerizable components. The content of the repeating unit(s) represented by Formula (i) in the copolymer may be determined suitably according to the structure of the copolymer and the design of a photosensitive layer composition, but is preferably in the range of 1 to 99 mole%, more preferably 5 to 40 mole%, and still more preferably 5 to 20 mole% with respect to the total number of moles.

Any known radical polymerizable monomer may be used as the copolymerizable component without restriction. Specific examples thereof include those described in "Polymer Data Handbook -Basic-(edited by Soc. Polymer Science, Japan, and published by Baihukan in 1986)". One copolymerizable component may be used alone, or two or more copolymerizable components can be used together.

The molecular weight of the particular binder polymer used is determined suitably according to a desired image-forming property and printing durability. The molecular weight is preferably in the range of 2,000 to 1,000,000, more preferably 5,000 to 500,000, and still more preferably 10,000 to 200,000.

The binder polymer used may be one particular binder polymer or a mixture of at least one particular binder polymer and one or more other binder polymers. Other binder polymer(s) is contained in an amount in the range of 1 to 60% by mass, preferably 1 to 40% by mass, and still more preferably 1 to 20% by mass with respect to the total weight of the binder polymer(s). Any known polymer may be used as other binder polymer without restriction, and typical examples thereof include binders having an acrylic main chain and urethane binders, which are commonly used in the art.

The total amount of the particular binder polymer(s) and other binder polymer(s) in the photosensitive layer composition may be determined suitably, but is generally in the range of 10 to 90%, preferably 20 to 80%, and still more preferably 30 to 70% by mass with respect to the total mass of the nonvolatile components of the photosensitive layer composition.

The acid value (meg/g) of the binder polymer is preferably in the range of 2.00 to 3.60.

-Other binder polymer used together with particular binder polymer-

Other binder polymer used together with particular binder polymer is preferably a binder polymer having a group which can be polymerized with a free radical (radically polymerizable group).

The radically polymerizable group is not particularly limited, as long as it can be polymerized by a free radical. Examples thereof include α-substituted methylacrylic groups [$-OC(=O)-C(-CH_2Z)=CH_2$] wherein Z is a hydrocarbon group having a hetero atom bonded to the $CH_2$ group, an acrylic group, a methacrylic group, an allyl group, and a styryl group. The radically polymerizable group is preferably an acrylic group and/or a methacrylic group.

The content of the radical polymerizable group in the binder polymer (content of radically polymerizable unsaturated double bond determined by iodimetry) is preferably 0.1 to 10.0 mmol, more preferably 1.0 to 7.0 mmol, and most preferably 2.0 to 5.5 mmol per g of the binder polymer from the viewpoints of sensitivity and storage stability.

In addition, other binder polymer preferably has an alkali-soluble group. The content of the alkali-soluble group in the binder polymer (acid value determined by neutralization titration) is preferably 0.1 to 3.0 mmol, more preferably 0.2 to 2.0 mmol, and most preferably 0.45 to 1.0 mmol per g of the binder polymer from the viewpoints of precipitating property of development scum and printing durability.

The weight-average molecular weight of the binder polymer is preferably in the range of 2,000 to 1,000,000, more preferably 10,000 to 300,000, and most preferably 20,000 to 200,000 from the viewpoints of film-forming property (printing durability) and solubility thereof in a coating solvent.
The glass transition temperature (Tg) of the binder polymer is preferably in the range of 70 to 300°C, more preferably 80 to 250°C, and most preferably 90 to 200°C from the viewpoints of storage stability, printing durability, and sensitivity.
The binder polymer preferably has an amide group or an imide group in the molecule, especially a methacrylamide or methacrylamide derivative to raise the glass transition temperature of the binder polymer.

[Other components)

The photosensitive layer of the planographic printing plate precursor may contain, in addition to the primary components described above, other components suitable for application, and the production method thereof. Hereinafter, examples of additives which the photosensitive layer may have will be described.

-Coloring agent-

The photosensitive layer of the planographic printing plate precursor used in the invention may contain a dye or a pigment for the purpose of coloration thereof. A colored photosensitive layer can improve so-called plate-inspection properties such as visibility of images formed on the printing plate and adaptability of the plate to an image densitometer. Typical examples of the coloring agent include pigments such as phthalocyanine pigments, azo pigments, carbon black, and titanium oxide; dyes such as ethyl violet, crystal violet, azo dyes, anthraquinone dyes, and cyanine dyes. Among them, the coloring agent is preferably a cationic dye.
The amount of the dye(s) and/or pigment(s) added as the coloring agent(s) is preferably about 0.5 to 5% by mass with respect to the total amount of the nonvolatile components of the photosensitive layer composition.

-Polymerization inhibitor-

The photosensitive layer of the planographic printing plate precursor preferably contains a compound having a polymerizable ethylenic unsaturated double bond, i.e., a thermal polymerization inhibitor in a small amount for prevention of undesirable thermal polymerization of the polymerizable compound. Typical examples of the thermal polymerization inhibitor include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), and a cerium(I) salt of N-nitrosophenylhydroxyamine. The amount of the thermal polymerization inhibitor added is preferably about 0.01 to about 5% by mass with respect to the mass of the nonvolatile components of the photosensitive layer composition. In addition, in order to prevent oxygen from inhibiting polymerization, the photosensitive layer may contain a higher fatty acid derivative such as behenic acid or behenic acid amide, if necessary. Such a compound may be localized in the surface portion of the layer during the applied layer is dried. The amount of the higher fatty acid derivative added is preferably about 0.5 to about 10% by mass with respect to the nonvolatile components of the photosensitive layer composition.

-Other additives-

In addition, the photosensitive layer of the planographic printing plate precursor may contain other additives known in the art, including an inorganic filler and a plasticizer to improve physical properties of a cured film and a sensitizing agent to improve ink-receiving property of the photosensitive layer surface. Examples of the plasticizer include dioctyl phthalate, didodecyl phthalate, triethylene glycol dicaprylate, dimethylglycol phthalate, tricresyl phosphate, dioctyl adipate, dibutyl sebacate, and triacetylglycerin. The plasticizer can be added generally in an amount of 10% by mass or less with respect to the total mass of the binder polymer(s) and the addition-polymerizable compound(s).
The photosensitive layer of the planographic printing plate precursor used in the invention may also contain an UV initiator, and/or a heat cross-linking agent for the purpose of enhancing the effects of heating and exposure after development and in turn improving film strength (printing durability) described later.

[Support)

Any known support used in planographic printing plate precursors may be used without restriction.
The support is a plate-shaped substrate having dimensional stability, and examples thereof include paper; paper on which a plastic resin (e.g., polyethylene, polypropylene, and polystyrene) is laminated; metal plates (e.g., aluminum, zinc, and copper plates); plastic films (e.g., cellulose diacetate, cellulose triacetate, cellulose propionate,

cellulose butyrate, cellulose acetate butyrate, cellulose nitrate, polyethylene terephthalate, polyethylene, polystyrene, polypropylene, polycarbonate, and polyvinylacetal films); and paper and plastic films on which the above-described metal is laminated or deposited. The surface of the support may be processed physically and/or chemically by a known method or methods for improvement in hydrophilicity and strength, if necessary.

The support is preferably paper, a polyester film or an aluminum plate. Among them, the support is particularly preferably an aluminum plate, which is superior in dimensional stability, relatively inexpensive, and can provide a surface having good hydrophilicity and sufficient strength by surface treatment, which is conducted as needed. In addition, the support is also preferably a composite sheet in which an aluminum sheet is bonded to a polyethylene terephthalate film and which is described in JP-B No. 48-18327.

The aluminum plate most suitable as the support is a metal plate containing as the main component thereof aluminum, which has dimensional stability, and is selected from a pure aluminum plate, metal plates containing as the main component thereof aluminum, and containing a trace amount of other element(s), and plastic films and paper on which aluminum or an aluminum alloy is laminated or vapor-deposited. As described above, the generic term "aluminum support" is used for supports containing aluminum or an aluminum alloy. Examples of the elements other than aluminum contained in the aluminum alloy include silicon, iron, manganese, copper, magnesium, chromium, zinc, bismuth, nickel, and titanium, and the content thereof in the alloy is 10% by mass or less. Although the support is most preferably a pure aluminum support in the invention, the aluminum plate may contain a trace amount of other element(s). This is because it is difficult to prepare completely pure aluminum from the viewpoint of refining techniques. As described above, the composition of the aluminum plate is not particularly specified, and any one of aluminum plates known and used in the art, for example, those stipulated in JIS A1050, A1100, A3103, and A3005, may be used arbitrarily in the invention.

The thickness of the aluminum support is about 0.1 mm to 0.6 mm. The thickness may be suitably changed according to the size of a printing machine, the dimension of a desired printing plate, and/or needs of user.

The aluminum support may be subjected to surface treatment described below.

[Surface roughening treatment)

Examples of a surface roughening method include mechanical surface roughening, chemical etching, and electrolytic graining disclosed in JP-A No. 56-28893. In addition, a mechanical surface roughening method such as an electrochemical surface roughening method of electrochemically roughening an aluminum support surface in a hydrochloric or nitric acid electrolyte, a wire brush graining method of scratching an aluminum support surface with metal wires, a ball graining method of roughening an aluminum support surface with abrasive balls and an abrasive; or a brush graining method of roughening an aluminum support surface with a nylon brush and an abrasive can be conducted as the surface roughening method. One of these surface roughening methods may be conducted, or two or more of them can be conducted. Among the surface roughening methods described above, preferable is the electrochemical method of chemically roughening an aluminum support surface in a hydrochloric or nitric acid electrolyte, and the amount of anodic electric current (current when the support serves as a positive electrode) is preferably in the range of 50 to 400 $C/dm^2$. More specifically, the alternate current and/or direct current electrolysis is preferably carried out in an electrolyte containing 0.1 to 50% of hydrochloric or nitric acid at a temperature of 20 to 80°C at an electric current density of 100 to 400 $C/dm^2$ for a period of 1 second to 30 minutes.

The aluminum support subjected to the surface roughening treatment may be further chemically etched in an acid or alkali. Typical examples of the etching agent include sodium hydroxide, sodium carbonate, sodium aluminate, sodium metasilicate, sodium phosphate, potassium hydroxide, and lithium hydroxide. The concentration and the temperature are preferably 1 to 50%, and 20 to 100°C, respectively. After etching, the support is washed with an acid to remove stains remaining on the support surface (smuts). The acid is preferably nitric acid, sulfuric acid, phosphoric acid, chromic acid, hydrofluoric acid, and/or borofluoric acid. In particular, a method for removing smuts after electrochemical surface roughening treatment is preferably a method described in JP-A No. 53-12739 wherein the support surface is brought into contact with 15 to 65% by mass of sulfuric acid at a temperature of 50 to 90°C, and/or a method described in JP-B 48-28123 wherein the surface is alkaline-etched. The method for removing smuts and conditions therefor are not particularly limited, as long as the surface roughness of the treated surface Ra is about 0.2 to 0.5 μm.

[Anodizing process)

The aluminum support on which an oxide layer is formed in the above manner are subjected to anodizing treatment. In the anodizing treatment, One or at least two of aqueous solutions of sulfuric acid, phosphoric acid, oxalic acid, and boric acid/sodium borate are used as the main component(s) of the electrolytic solution contained in an electrolytic bath. The electrolyte solution may contain other components commonly contained in the aluminum alloy plate, the electrodes, tap water, and underground water. In addition, the electrolyte solution may also contain second and third components. Examples of the second and third components include cations including metal ions such as Na,

K, Mg, Li, Ca, Ti, Al, V, Cr, Mn, Fe, Co, Ni, Cu, and Zn, and an ammonium ion; and anions such as nitrate, carbonate, chloride, phosphate, fluoride, sulfite, titanate, silicate, and borate ions. The concentration thereof in the electrolyte solution may be about 0 to 10,000 ppm. Conditions of the anodizing treatment are not particularly limited, but the support is preferably subjected to direct or alternate current electrolysis at 30 to 500 g/L at a processing solution temperature of 10 to 70°C at an electric current density of 0.1 to 40 A/$m^2$. The thickness of the anodic oxidation film formed is in the range of 0.5 to 1.5 μm, and preferably in the range of 0.5 to 1.0 μm. Conditions of the anodic oxidation are preferably selected so that the diameter and density of micropores present in the anodic oxidation film of the support prepared as described above respectively become 5 to 10 nm and $8\times10^{15}$ to $2\times10^{16}$ pores/$m^2$.

Any method known in the art may be used in making the support surface hydrophilic. Particularly preferable is treatment of making the support surface hydrophilic with silicate, or polyvinyl phosphonic acid. The film is formed such that the amount of silicon or phosphor element is preferably 2 to 40 mg/$m^2$, and more preferably 4 to 30 mg/$m^2$. The coating amount can be measured in accordance with a fluorescent X-ray analytic method.

The treatment of making a support surface hydrophilic can be carried out, for example, by immersing an aluminum support on which an anodic oxidation film is formed in an aqueous solution containing an alkali metal silicate or polyvinylphosphonic acid at a concentration of 1 to 30%, and preferably 2 to 15% by mass, and having a pH at 25°C in the range of 10 to 13 at a temperature of 15 to 80°C for a period of 0.5 to 120 seconds.

The alkali metal silicate used in the treatment can be sodium silicate, potassium silicate, and/or lithium silicate. The hydroxide used to raise the pH of the aqueous alkali metal silicate solution can be sodium hydroxide, potassium hydroxide, and/or lithium hydroxide. The processing solution may contain an alkaline earth metal salt and/or a salt of a metal of Group IVB. Examples of the alkaline earth metal salt include water-soluble salts including nitric acid salts such as calcium nitrate, strontium nitrate, magnesium nitrate, and barium nitrate, sulfates, hydrochlorates, phosphates, acetates, oxalates, and borates. Examples of the salt of the metal of the Group IVB include titanium tetrachloride, titanium trichloride, titanium potassium fluoride, titanium potassium oxalate, titanium sulfate, titanium tetraidodide, zirconium oxychloride, zirconium dioxide, zirconium oxychloride, and zirconium tetrachloride.

One of the alkaline earth metal salts and Group IVB metal salts may be used, or two or more of them can be used together. The content of the metal salt(s) is preferably in the range of 0.01 to 10% and more preferably in the range of 0.05 to 5.0% by mass. Alternatively, silicate electrodeposition described in U.S. Patent No. 3,658,662 is also effective. Further, a combination of a substrate subjected to electrolytic graining as disclosed in JP-B No. 46-27481, and JP-A Nos. 52-58602 or 52-30503 and the above-described anodizing treatment and treatment of making a support surface hydrophilic is also useful as surface treatment. [Production of planographic printing plate precursor)

The planographic printing plate precursor used in the invention has on a support a photosensitive layer and a protective layer in that order, and optionally has any other layer such as an undercoat layer. The planographic printing plate precursor is produced by dissolving the various components described above in at least one suitable solvent to form coating solutions and applying the resulting solutions onto a support.

The photosensitive layer is formed by dissolving the components thereof in an organic solvent to form a photosensitive layer coating solution and applying the coating solution to a support or an undercoat layer.

Examples of the solvent used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethylsulfoxide, γ- butylolactone, methyl lactate, and ethyl lactate. One of these solvents may be used alone, or two or more of them can be used together. The concentration of the solid matter in the photosensitive layer coating solution is generally 2 to 50% by mass.

The coating amount of the photosensitive layer, which can mainly influence sensitivity and developing property of the photosensitive layer, and strength and printing durability of the exposed layer, may be selected suitably according to applications. It the coating amount is too small, printing durability becomes insufficient. On the contrary, if it is too large, sensitivity decreases, and consequently exposure and development respectively take longer time. In the case of a planographic printing plate precursor for scanning exposure, the amount of the photosensitive layer is preferably in the range of about 0.1 to about 10 g/$m^{2,}$ and more preferably 0.5 to 5 g/$m^2$ in terms of dry mass.

[Physical properties of photosensitive layer)

In regard to the physical properties of the photosensitive layer, the developing speed of unexposed portions in an alkaline developing solution having a pH of 10 to 13.5 is preferably 80 nm/sec or more, and the permeation speed of the alkaline developing solution into exposed portions is preferably 50 nF/ sec or less.

Here, the developing speed of unexposed portions in an alkaline developing solution having a pH of 10 to 13.5 is a value obtained by dividing the thickness (nm) of a photosensitive layer by a time which development required (sec). The permeation speed of the alkaline developing solution in exposed portions is a value showing a rate of change in electrostatic capacitance (F) when the photosensitive layer is formed on a conductive support and the support is immersed in a developing solution.

Hereinafter, a method for measuring the "developing speed of unexposed portions in an alkaline developing solution" and the "permeation speed of the alkaline developing solution in exposed portions" in the invention will be described in detail.

[Measurement of developing speed of exposed portions in alkaline developing solution]

The developing speed of unexposed portions in an alkaline developing solution is a value obtained by dividing the thickness (nm) of a photosensitive layer by a time which development required (sec).

In measuring the developing speed in the invention, an unexposed photosensitive layer formed on an aluminum support is immersed in an alkaline developing solution (30°C) having a pH in the range of 10 to 13.5, and the dissolving behavior of the photosensitive layer is checked with a DRM interference wave-measuring instrument as shown in Figure 1. Figure 1 is a schematic view of the DRM interference wave-measuring instrument used in determining the dissolving behavior of a photosensitive layer. A change in film thickness is detected by using the interference caused by light having a wavelength of 640 nm. When development does not cause swelling of the negative photosensitive layer and dissolution of the negative photosensitive layer starts with dissolution of the surface thereof, the layer gradually thins with the passage of developing time, and an interference wave corresponding to a film thickness is obtained. Alternatively, when development causes swelling of the negative photosensitive layer and the swollen layer separates from a support in the form of masses, penetration of the developing solution in the layer causes the layer to thicken due to swelling thereof and thin due to separation thereof from the support, and thus a distinct interference wave cannot be obtained.

Measurement is continued under these conditions until the photosensitive layer is completely removed. The developing speed is obtained according to the following equation on the basis of a time necessary to completely remove the photosensitive layer and to thereby decrease the layer thickness to 0 (development completion time) (second) and the initial thickness of the photosensitive layer (nm). A high developing speed means that a layer is readily removed with a developing solution and that the development property of the layer is good.

Developing speed (at unexposed portions) =

Initial thickness of photosensitive layer (nm)/Development completion time (second)

[Measurement of permeation speed of alkaline developing solution in exposed portions]

As described above, the permeation speed of an alkaline developing solution in exposed portions refers to a speed of change in electrostatic capacitance (nF) when a photosensitive layer is formed on a conductive support and the support is immersed in a developing solution.

In order to measure electrostatic capacity serving as an indicator of the permeability of the alkaline developing solution, the following method can be conducted. As shown in Fig. 2, an aluminum support having thereon a photosensitive layer is exposed to light at a predetermined light amount, and the support, which has the resultant cured photosensitive layer and serves as an electrode, is then immersed in an alkaline developing solution having a pH in the range of 10 to 13.5 and kept at 28°C. A conventional electrode serving as a counter electrode is also immersed in the alkaline developing solution and a wire or cable is connected to the electrode and the aluminum support. Then, an electrical voltage is applied to the resultant circuit and electrostatic capacitance is measured. After the application and measurement are started, the developing solution permeates in the photosensitive layer with the passage of time, and then reaches the interface between the support and the photosensitive layer. During this process, electrostatic capacity changes.

The permeation speed can be obtained according to the following equation on the basis of a time from a time when the measurement has started to a time when electrostatic capacity no longer changes (second) and the saturated electrostatic capacity of the photosensitive layer (nF). The lower the permeation speed, the lower the permeability of the developing solution.

$$\text{Permeation speed of developing solution (in exposed portions)} = \text{Saturated electrostatic capacity of photosensitive layer (nF)}/\text{time}$$

from a time when the measurement has started to a time when electrostatic capacity no longer changes (second)

As for the physical properties of the photosensitive layer of the planographic printing plate precursor of the invention, the developing speed of unexposed portions in an alkaline developing solution having a pH of 10 to 13.5 which developing speed is determined in the above manner is more preferably 80 to 400 nm/ second and still more preferably 90 to 200 nm/ second. On the other hand, the permeation speed of the alkaline developing solution at exposed portions is more preferably 0 to 50 nF/ second and still more preferably 0 to 10 nF/ second.

Any of methods commonly practiced in the art may be conducted to control the developing speed of unexposed portions of the photosensitive layer and the permeation speed of the alkaline developing solution into the cured photosensitive layer, or exposed portions. For example, in order to accelerate the developing speed of unexposed portions, it is effective that the photosensitive layer contains a hydrophilic compound. Moreover, in order to suppress penetration of the developing solution into exposed portions, it is effective that the photosensitive layer contains a hydrophobic compound.

Each of the developing speed of the photosensitive layer and the permeation speed of the developing solution can be easily adjusted at the above-described, preferable range by using the specific binder polymer previously described.

[Intermediate Layer (Undercoat layer)]

The planographic printing plate precursor may have an intermediate layer (also referred to as an undercoat layer) for the purpose of improving adhesiveness between the photosensitive layer and the support and the staining property of the precursor. Specific examples of such an intermediate layer include those described in JP-B No. 50-7481, JP-A Nos. 54-72104, 59-101651, 60-149491, 60-232998, 3-56177, 4-282637, 5-16558, 5-246171, 7-159983, 7-314937, 8-202025, 8-320551, 9-34104, 9-236911, 9-269593, 10-69092, 10-115931, 10-161317, 10-260536, 10-282682 and 11-84674, and Japanese Patent Application Nos. 8-225335, 8-270098, 9-195863, 9-195864, 9-89646, 9-106068, 9-183834, 9-264311, 9-127232, 9-245419, 10-127602, 10-170202, 11-36377, 11-165861, 11-284091 and 2000-14697.

[Protective Layer]

When the photosensitive layer of the planographic printing plate precursor is a negative-type radically polymerizble photosensitive layer, it is needed to provide a protective layer (also referred to as an overcoat layer) on the photosensitive layer to enable exposure of the precursor in an atmosphere. The protective layer prevents low molecular-weight compounds which inhibit image forming reaction caused by exposure of the photosensitive layer, such as oxygen and basic substances existing in an atmosphere, from entering the photosensitive layer, which makes it possible to conduct exposure in an atmosphere. Accordingly, a property which the protective layer is required to have is that the permeating property of the low molecular weight compounds such as oxygen in the protective layer is low. Moreover, it is preferable that the protective layer does not substantially inhibit light used to expose the planographic printing plate precursor from passing through the protective layer, has strong adhesion between the protective layer and the photosensitive layer, and can be easy to remove in the development step of an exposed printing plate. Devices relating to a protective layer satisfying the above demands have been conventionally implemented, as detailed in U.S. Patent No. 3,458,311 and JP-B No. 55-49729. The material of the protective layer is preferably a relatively good crystalline, water-soluble and high molecular weight compound. Specifically, water-soluble polymers such as polyvinyl alcohol, polyvinyl pyrrolidone, acidic celluloses, gelatin, gum arabic and polyacrylic acid are known as such. However, use of polyvinyl alcohol as the main component of the protective layer is effective in obtaining best basic characteristics such as an oxygen-blocking property and removability during development.

Polyvinyl alcohol used in the protective layer may be partly substituted with ester, ether and/or acetal, insofar as it contains an unsubstituted vinyl alcohol unit for achieving an oxygen-blocking property and water-solubility, which are essential to the protective layer. In addition, a part thereof may have other copolymerizing component. The polyvinyl alcohol can be one which have been hydrolyzed in a proportion of 71 to 100% and which have a molecular weight in the range of 300 to 2,400. Specific examples of such polyvinyl alcohol include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 manufactured by Kuraray Co., Ltd.

The components of the protective layer (kind of PVA, and use of other additives) and the amounts thereof are

determined according to a desired oxygen-blocking property, removability during development, fogging property, adhesiveness, and scratch resistance of the protective layer. Generally, the higher the hydrolysis rate of the PVA (the higher the content of unsubstituted vinyl alcohol units in the protective layer), the better the oxygen-blocking property of the protective layer and the sensitivity of the printing plate precursor. Moreover, the thicker the protective layer, the better the oxygen-blocking property of the protective layer and the sensitivity of the printing plate precursor. However, extreme rising of the oxygen-blocking property may lead to undesirable polymerization reaction during production and storage, and fogging, which is undesired, and thickening of image lines during image exposure. Adhesion between the protective layer and the image portions and scratch resistance of the protective layer are also very important in handling printing plates. When a printing plate has a hydrophilic layer made of a water-soluble polymer and laminated on a photosensitive layer, which is oleophilic, these layers insufficiently adhere to each other, which causes the hydrophilic layer to often and undesirably separate from the printing plate. Portions of the printing plate having no protective layer are exposed to air, and oxygen included in the air inhibits polymerization in the photosensitive layer, generating defects such as insufficient hardening of the photosensitive layer. In order to solve this problem, various methods for improving adhesion between the two layers have been proposed. For example, certain U.S. Patents disclose that a hydrophilic layer having strong adhesion between a photosensitive layer and the hydrophilic layer can be obtained by adding 20 to 60 % by mass of an acrylic emulsion or a water-insoluble vinylpyrrolidone-vinyl acetate copolymer to a hydrophilic polymer mainly containing polyvinyl alcohol and applying the resulting composition onto a photosensitive layer.

These conventionally known techniques may be applied to the protective layer used in the invention. Methods of forming such a protective layer are detailed in, for example, U.S. Patent No. 3,458,311 and JP-B No. 55-49729.

It is preferable to use both polyvinyl alcohol and polyvinylpyrrolidone from the viewpoints of adhesive strength, sensitivity and prevention of fogging. The mass ratio of polyvinyl alcohol to polyvinylpyrrolidone is preferably one third or less. The coating amount of these polymers is preferably 1.0 to 3.0 g/$m^2$.

<Plate making method>

Hereinafter, the method of making a planographic printing plate (plate-making method) according to the invention will be described.

The method of making a planographic printing plate according to the invention includes: exposing the planographic printing plate precursor described above to light having a wavelength of 750 nm to 1,400 nm, and then developing the exposed planographic printing plate in a developing solution containing at least one antigelling agent selected from the group consisting of monoalcohol compounds and monoketone compounds substantially without heat and washing treatments. The traveling speed of the planographic printing plate during the development is preferably 1.25 m/min or more.

The plate-making method is of course suitable for plate making from the planographic printing plate precursor described above, but is also preferably used for a planographic printing plate precursor having a negative-type polymerizable photosensitive layer containing at least an infrared absorbent, a polymerization initiator, and a polymerizable compound, the solubility of which in an alkaline developing solution decreases due to exposure thereof to light having a wavelength of 750 nm to 1,400 nm. Specifically, the plate-making method is suitable for any of the photosensitive layers containing the "infrared absorbent, polymerization initiator, and polymerizable compound" described in the section of each of the components of the photosensitive layer of the planographic printing plate precursor, and the photosensitive layer may further include or may not include an additional known binder polymer.

The photosensitive layer, to which the method of making a planographic printing plate is applied, preferably has the following physical properties: the developing speed of unexposed portions in an alkaline developing solution having a pH of 10 to 13.5 being 80 nm/sec or more, and the permeation speed of the alkaline developing solution in exposed portions being 50 nF/ sec or less. Control of the developing speed of unexposed portions of the photosensitive layer and the permeation rate of an alkaline developing solution in the cured photosensitive layer may be carried out according to ordinary methods. In addition to using the particularly binder polymer, addition of a hydrophilic compound, for example, is effective in accelerating the developing speed of unexposed portions, and addition of a hydrophobic compound is effective in suppressing the permeation of the developing solution into exposed portions.

[Exposure)

Any light having a wavelength of 750 to 1,400 nm may be used, but an infrared laser is preferable as a light source for exposure in the invention. The planographic printing plate precursor is preferably subjected to image exposure with a solid laser or semiconductor laser emitting an infrared light with a wavelength of 750 to 1,400 nm. The output of the laser is preferably 100 mW or more, and use of a multi-beam laser device is preferable for shortening exposure time. The exposure time per image pixel is preferably 20 μseconds or less. The energy of the laser applied to the planographic printing plate precursor is preferably 10 to 300 mJ/$cm^2$. If the exposure energy is too low, curing of the photosensitive

layer does not proceed sufficiently. Alternatively, if the exposure energy is too high, the photosensitive layer may be damaged due to laser abrasion.

In the exposure, the light beams from a light source may be overlapped. The overlap means that a sub scanning pitch width is smaller than the diameter of a beam. For example, when a beam diameter is expressed by the full width at the half maximum intensity (FWHM), the degree of overlap can be expressed quantitatively by an overlapping coefficient, FWHM/sub scanning pitch width. In the invention, the overlapping coefficient is preferably 0.1 or more.

A method of scanning a planographic plate precursor with a light source of an exposure apparatus used in the invention is not particularly restricted, and the exposure may be carried out either by scanning the external or internal wall of a cylinder to which esternal or internal wall a printing plate precursor is attached, or the surface of a printing plate precursor disposed flat. The light source may be single-channel type or multi-channel type, but a multi-channel light source is preferably used for scanning the external surface of a cylinder to which external surface a printing plate precursor is attached.

The planographic printing plate exposed is developed without heating and washing treatments. This lack of heating treatment allows suppression of non-uniformity of images which is caused by heating treatment. In addition, lack of heating and washing treatments allows stable high-speed processing in development.

[Development)

In the development, the developing solution contains at least one antigelling agent selected from the group consisting of monoalcohol compounds and monoketone compounds. The present invention relates to their use as antigelling agents.

As described above, the processing speed during development, i.e., the traveling speed of the planographic printing plate (line speed) during development, is preferably 1.25 m/min or more and still more preferably 1.35 m/min or more in the invention. The upper limit value of the traveling speed is not particularly limited, but is preferably 3 m/min or less from the viewpoint of conveyance stability.

Hereinafter, the developing solution for use in the invention will be described.

[Developing solution)

The developing solution contains at least one antigelling agent selected from the group consisting of monoalcohol compounds and monoketone compounds.

[Monoalcohol and ketone compounds)

The monoalcohol and ketone compounds whose use as antigelling agents is claimed are monofuctional compounds containing an alcohol or ketone in the molecule. Use of such a compound allows suppression of gelation which is caused by the water-soluble polymer derived from a protective layer and dissolved in the developing solution. The monoalcohol and ketone compounds preferably have a high-boiling point, since such compounds do not easily evaporate and are effective for a longer period of time.

The reason for the monoalcohol or ketone compound being effective in preventing gelation seems to be the followings. A water-soluble polymer having an unsubstituted alcohol at the terminal, such as polyvinyl alcohol or a derivative thereof, used as the main component of the protective layer of the planographic printing plate precursor according to the invention generally tends to gelate in an aqueous solution. In particular, a water-soluble polymer contained at a high concentration or having a high degree of saponification is more likely to gelate. Accordingly, in the plate-making method having no water washing treatment, the concentration of the water-soluble polymer in the developing solution for processing protective layer increases, causing gel in the developing solution.

The gelation mechanism will be described below. The water-soluble polymer having an unsubstituted alcohol at the terminal is known to form interaction in the molecule or between the molecules via hydrogen bonds and gelate, as shown in the following scheme A.

A

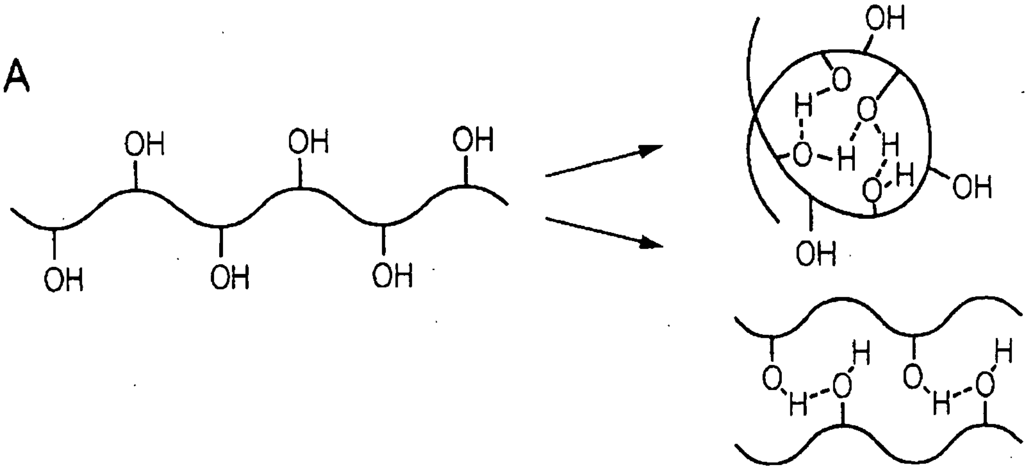

When a monoalcohol or monoketone compound is present with the water-soluble polymer having an unsubstituted alcohol at the terminal, the compound seems to interact with a part of the unsubstituted OH groups of the water-soluble polymer, consequently suppressing gelation of the water-soluble polymer, as shown in the following scheme B.

B

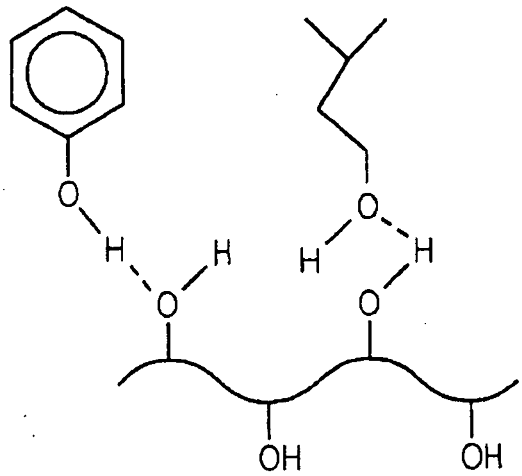

On the other hand, use of a compound having multiple functional groups seems to accelerate the gelation, since the compound functions as a cross-linking agent for the water-soluble polymer, as shown in the following scheme C.

C

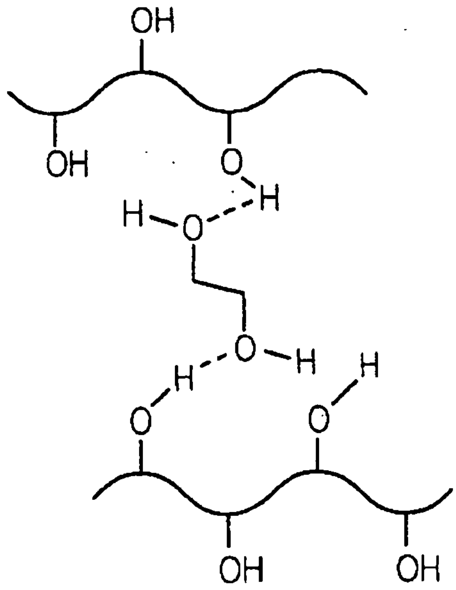

For that reason, the use of monoalcohol compounds and monoketone compounds suppresses gelation which is caused by the water-soluble polymer of the protective layer.

Gel occurring in the developing solution usually deteriorates printing efficiency and generates stains in non-image portions, and results in clogging of tubing and spray tubes, demanding removal of the gel by replacing the treatment solution, and deteriorating operational efficiency. However, the plate-making method prevents such gelation, eliminating the labor for replacing a developing solution for an extended period of time and thus allowing suppression of stains in non-image portions and of a decrease in operational efficiency.

Typical examples of the monoalcohol and ketone compounds used in the invention include n-propyl alcohol, iso-propyl alcohol, n-butyl alcohol, iso-butyl alcohol, sec-butyl alcohol, t-butyl alcohol, n-amyl alcohol, sec-amyl alcohol, t-amyl alcohol, cyclohexanol and derivatives thereof, phenoxyethanol and derivatives thereof, phenol and derivatives thereof, diethylketone, and cyclohexanone and derivatives thereof.

One of these compounds may be used alone, or two or more of them can be used together. The content of the monoalcohol and/or monoketone compound in the developing solution is preferably 0.01 to 10%, more preferably 1 to 8%, and still more preferably 2 to 8% by mass.

In addition, the developing solution preferably contains an aromatic anionic surfactant in addition to the monoalcohol and/or monoketone compound. Hereinafter, the composition of the developing solution will be described in detail.

[Aromatic anionic surfactant)

The aromatic anionic surfactant used in the developing solution used is effective in accelerating development and in dispersing and stabilizing the components of the engative-type polymerizable photosensitive layer and the protective layer in the developing solution, and thus in stabilizing the development. The aromatic anionic surfactant is preferably a compound represented by the following Formula (A) or (B).

Formula (A)

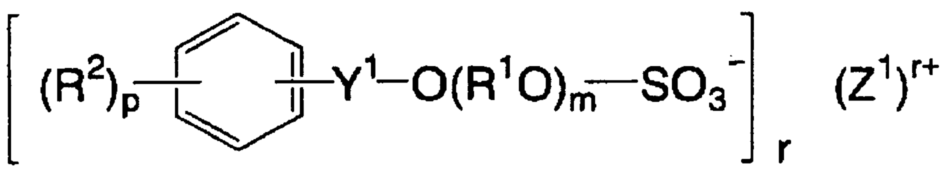

Formula (B)

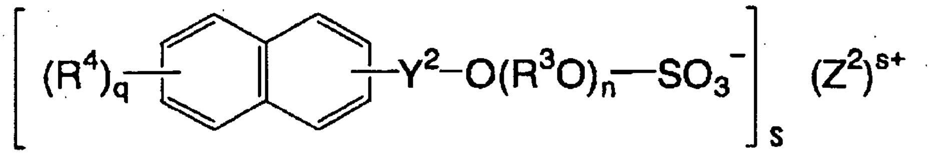

In Formula (A) or (B), $R^1$ and $R^3$ each represent a linear or branched alkylene group having 1 to 5 carbon atoms, and specific examples thereof include an ethylene group, a propylene group, a butylene group, and a pentylene group. Each of $R^1$ and $R^3$ is preferably an ethylene group or a propylene group.

m and n each represent an integer of 1 to 100, and is preferably an integer of 1 to 30 and more preferably an integer of 2 to 20. When m is 2 or more, plural $R^3$s may be the same as or different from each other. Similarly, when n is 2 or more, plural $R^5$s may be the same as or different from each other.

$R^2$ and $R^4$ each represent a linear or branched alkyl group having 1 to 20 carbon atoms, and typical examples thereof include a methyl group, an ethyl group, a propyl group, a butyl group, a hexyl group, and a dodecyl group. Each of $R^2$ and $R^4$ is preferably a methyl group, an ethyl group, an iso-propyl group, a n-propyl group, a n-butyl group, an iso-butyl group, or a tert-butyl group.

p and q each represent an integer of 0 to 2. $Y^1$ and $Y^2$ each represent a single bond or an alkylene group having 1 to 10 carbon atoms, and is preferably a single bond, a methylene group, or an ethylene group and more preferably a single bond.

$(Z^1)^{r+}$ and $(Z^2)^{s+}$ each represent an alkali metal ion, an alkaline earth metal ion, or an unsubstituted or alkyl group-substituted ammonium ion, and typical examples thereof include a lithium ion, a sodium ion, a potassium ion, a magnesium ion, a calcium ion, an ammonium ion, and a secondary, tertiary or quaternary ammonium ion substituted with an alkyl group having 1 to 20 carbon atoms, an aryl group, or an aralkyl group. Each of $(Z^1)^{r+}$ and $(Z^2)^{s+}$ is preferably a sodium ion. r and s each are 1 or 2.

Hereinafter, specific examples thereof are shown, but the invention is not limited by these examples.

K-1

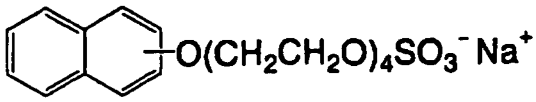

K-2

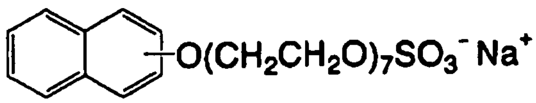

K-3

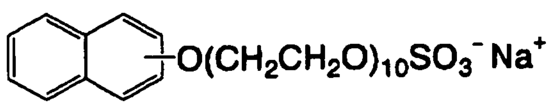

K-4

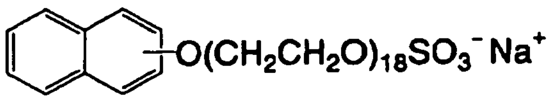

K-5

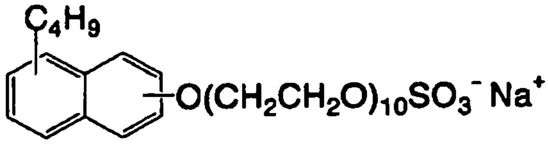

K-6

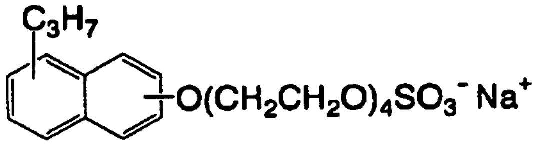

K-7

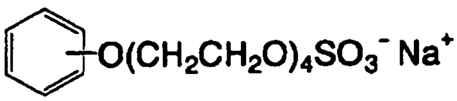

K-8

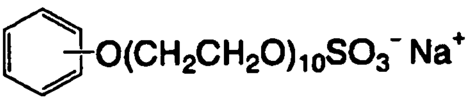

K-9

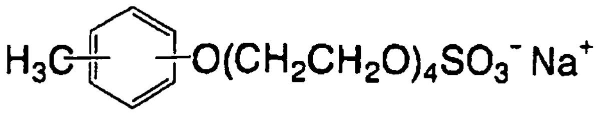

K-10

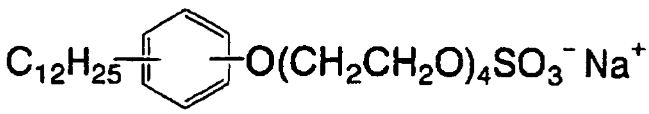

K-11

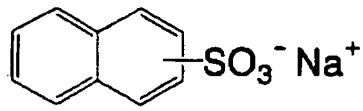

K-12

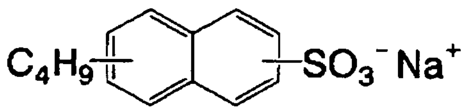

One of these aromatic anionic surfactants may be used alone, or two or more of them can be used together. The amount of the aromatic anionic surfactant added, i.e., the concentration of the aromatic anionic surfactant in the developing solution, is preferably in the range of 1.0 to 10% by mass and more preferably in the range of 2 to 10% by mass. A content of less than 1.0% by mass leads to deterioration in printing efficiency and a decrease in solubility of photosensitive layer components, while a content of more than 10% by mass least to a decrease in printing durability of the printing plate.

The developing solution may also contain other surfactant in addition to the aromatic anionic surfactant. Examples of other surfactant include nonionic surfactants including polyoxyethylene alkyl ethers such as polyoxyethylene naphthyl ether, polyoxyethylene alkyl phenyl ester, polyoxyethylene lauryl ether, polyoxyethylene cetyl ether, and polyoxyethylene stearyl ether, polyoxyethylene alkyl esters such as polyoxyethylene stearate, sorbitan alkyl esters such as sorbitan monolaurate, sorbitan monostearate, sorbitan distearate, sorbitan monooleate, sorbitan sesquioleate, and sorbitan trioleate, and monoglyceride alkyl esters such as glycerol monostearate, and glycerol monooleate.

The content of other surfactant in the developing solution is preferably 0.1 to 10% by mass in terms of effective component conversion.

[Chelating agent for bivalent metal)

The developing solution preferably contains a chelating agent for bivalent metal(s), for example, to suppress the adverse effects of calcium ions contained in hard water. Examples of the chelating agent for bivalent metal(s) include polyphosphates such as $Na_2P_2O_7$, $Na_5P_3O_3$, $Na_3P_3O_9$, $Na_2O_4P(NaO_3P)PO_3Na_2$, and Calgon (sodium polymetaphosphate); amino-polycarboxylic acids such as ethylenediamine tetraacetic acid and potassium, sodium, and amine salts thereof, diethylenetriamine pentaacetic acid and potassium and sodium salts thereof, triethylenetetramine hexaacetic acid and potassium and sodium salts thereof, hydroxyethylethylenediamine triacetic acid and potassium and sodium salts thereof, nitrilotriacetic acid and potassium and sodium salts thereof, 1,2-diaminocyclohexane tetraacetic acid and potassium and sodium salts thereof, and 1,3-diamino-2-propanol tetraacetic acid and potassium and sodium salts thereof; organic phosphonic acids such as 2-phosphonobutane tricarboxylic acid-1,2,4 and potassium and sodium salts thereof, 2-phosphonobutanone tricarboxylic acid-2,3,4 and potassium and sodium salts thereof, 1-phosphonoethane tricarboxylic acid-1,2,2 and potassium and sodium salts thereof, 1-hydroxyethane-1,1-diphosphonic acid and potassium and sodium salts thereof, and aminotri(methylenephosphonic acid) and potassium and sodium salts thereof. The chelating agent for bivalent metal(s) is preferably ethylenediamine tetraacetic acid or a potassium, sodium, or amine salt thereof, ethylenediamine tetra(methylenephosphonic acid) or a ammonium or potassium salt thereof, or hexamethylenediamine tetra (methylenephosphonic acid) or a ammonium or potassium salt thereof.

The optimum content of the chelating agent used depends on the hardness and the amount of hard water used. However, the content in the developing solution is generally in the range of 0.01 to 5 % by mass and preferably 0.01 to 0.5 % by mass.

The developing solution may contain an alkali metal salt of an organic acid and/or an alkali metal salt of an inorganic acid as a development control agent. For example, one salt or two or more of salts selected from sodium carbonate, potassium carbonate, ammonium carbonate, sodium citrate, potassium citrate, and ammonium citrate may be contained in the developing solution.

[Alkali agent)

Examples of the alkali agent contained in the developing solution include inorganic alkali agents such as trisodium phosphate, tripotassium phosphate, triammonium phosphate, sodium borate, potassium borate, ammonium borate, sodium hydroxide, potassium hydroxide, ammonium hydroxide, and lithium hydroxide; and organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. One of these alkali agents may be used, or two or more of them can be used together.
In addition to the above compounds, the alkali agent can be alkali silicate. The alkali silicate may be used in combination with a base. The alkali silicate salt used is a salt that becomes alkaline when dissolved in water, and examples thereof include sodium silicate, potassium silicate, lithium silicate, and ammonium silicate. One of these alkali silicates may be used, or two or more of them can be used together.
The developing solution can be optimally adjusted by controlling the mixing ratio and the concentrations of silicon oxide $SiO_2$, a component of the silicate used as a hydrophilizing component for a support, and an alkali oxide $M_2O$ (M represents an alkali metal or an ammonium group) used as an alkali component. The mixing ratio (molar ratio) of silicon oxide $SiO_2$ to alkali oxide $M_2O$ ($SiO_2/M_2O$) is preferably in the range of 0.75 to 4.0, and more preferably in the range of 0.75 to 3.5 for the purpose of suppressing stains caused by leaving a support in the developing solution for two long period of time and by excessively dissolving (etching) an anodic oxide film on the support in the solution, or suppressing the generation of insoluble gas caused by the dissolved aluminum and silicate forming a complex.
From the viewpoints of suppression of dissolution (etching) of the anodic oxide film disposed on the support, a developing property, suppression of precipitation and crystal growth, and suppression of gelling of the alkaline silicate caused by neutralization of wastewater, the concentration of the alkali silicate in the developing solution is such that the content of silicon dioxide in the developing solution is preferably in the range of 0.01 to 1 mol/L and more preferably in a range of 0.05 to 0.8 mol/L.
The developing solution may further contain the following components in addition to the components described above, if necessary. Examples thereof include organic carboxylic acids such as benzoic acid, phthalic acid, p-ethylbenzoic acid, p-n-propylbenzoic acid, p-iso-propylbenzoic acid, p-n-butylbenzoic acid, p-t-butylbenzoic acid, p-2-hydroxyethylbenzoic acid, decanoic acid, salicyclic acid, and 3-hydroxy-2-naphthoic acid; organic solvents such as propylene glycol; and reducing agents, dyes, pigments, water softeners, and antiseptics.
The pH of the developing solution for use in the invention is preferably in the range of 10 to 12.5 and more preferably in the range of 11 to 12.5 at 25°C. Even when the developing solution has such a low pH, the developing solution contains the surfactant described above, and therefore exhibits an excellent developing property with respect to the non-image portion of a plate. Adjusting the pH of the developing solution to a relatively low value can lessen damage on image portions during development and facilitate handling of the developing solution.
The electric conductivity x of the developing solution is preferably 2 to 30 mS/cm and more preferably 5 to 25 mS/cm.
Here, it is preferable to add an alkali metal salt of an organic or inorganic acid to the developing solution as an agent for adjusting the electric conductivity of the developing solution.
The developing solution described above may be used as a developing solution and a developing replenisher, and is preferably used in automatic developing machines. In a case of an automatic developing machine, the developing solution becomes fatigued, as the amount of processed plates increases. Therefore, developing ability of the machine may be recovered by supplying a replenisher or new developing solution thereto. The replenishing method is preferably applied to the plate-making method. It is possible to obtain the advantages of the invention more efficiently by using the above-described developing solution for development of the planographic printing plate described above. Namely, the developing solution is suitable for the negative-type planographic printing plate precursor prepared by forming a photosensitive layer containing an infrared absorbent, a polymerization initiator, a polymerizable compound, and a binder polymer, and a protective layer in that order on a support.
In addition, replenishing by the method described in U.S. Patent No. 4,882,246 is preferable for recovering the developing ability of the automatic developing machine. In addition, the developing solutions described in JP-A Nos. 50-26601 and 58-54341 and JP-B Nos. 56-39464, 56-42860, and 57-7427 are also preferably used.
The planographic printing plate developed in this manner is post-treated with washing water, a rinsing solution containing a surfactant, and a desensitizing solution containing gum arabic, and/or a starch derivative, as described in JP-A Nos. 54-8002, 55-115045, and 59-58431. Various combinations of these treatments may be used as the post-treatment of the photosensitive layer of the planographic printing plate used in the invention. The planographic printing plate after these treatments is set in an offset printing machine, and used for printing on a number of sheets of paper.
In the method of making a planographic printing plate according to the invention, the developed images may be heated or the entire surface thereof may be irradiated for the purpose of improving image strength and printing

durability.

Very severe conditions may be used in the heating after development. Normally, the planographic printing plate is heated at a heating temperature in the range of 200 to 500°C. A lower heating temperature after development does not allow sufficient strengthening of the image, while a higher heating temperature may result in deterioration of the support and thermal decomposition of the image portions.

The planographic printing plate prepared in this manner is set in an offset printing machine and used for printing on a number of sheets of paper.

A plate cleaner used to remove stains on the plates during printing is a conventionally known plate cleaner for PS plates, and examples thereof include CL-1, CL-2, CP, CN-4, CN, CG-1, PC-1, SR, and IC (manufactured by Fuji Photo Film Co. Ltd.).

## EXAMPLES

Hereinafter, the invention will be described with reference to examples, but it should be understood that the invention is not restricted thereto.

### Examples 1 to 9, and Comparative Example 1

### Preparation of support

A JIS A1050 aluminum plate having a thickness of 0.30 mm and a width of 1,030 mm was subjected to the following surface treatment.

<Surface treatment>

The surface treatment was carried out by sequentially conducting the following steps (a) to (f). After each step and water washing, liquid remaining on the aluminum plate was removed with a nip roller.

(a) The aluminium plate was etched in a solution containing 26 mass % of sodium hydroxide and 6.5 mass % of aluminium ions at 70°C, until the amount of dissolved aluminum became 5 g/m$^2$. The etched plate was then washed with water.

(b) The aluminum plate was desmutted by spraying an aqueous solution including 1 mass % of nitric acid and 0.5 mass % of aluminium ions and kept at 30°C on the plate. The aluminum plate was then washed with water.

(c) The surface of the aluminum plate was continuously electrochemically roughened by applying an alternate current voltage having a frequency of 60 Hz to the plate immersed in an electrolyte which was an aqueous solution including 1 mass % of nitric acid, 0.5 mass % of aluminium ions and 0.007 mass % of ammonium ions and kept at 30°C. The alternate current voltage had a trapezoidal waveform, a time which it took to increase an electric current value from zero to peak (TP) was 2 mseconds, and a duty ratio was 1:1. In the treatment, a carbon electrode was used as a counter electrode. A ferrite electrode was used as an auxiliary anode. The electric current density was 25 A/dm$^2$ at the peak of electric current. The total amount of electricity used in this treatment and used when the aluminium plate served as an anode was 250 C/cm$^2$. A part (5%) of the current supplied from a power source was applied to the auxiliary anode. The aluminum plate was then washed with water.

(d) The aluminium plate was etched by spraying a solution containing 26 mass % of sodium hydroxide and 6.5 mass % of aluminium ions on the plate at 35°C, until the amount of dissolved aluminum became 0.2 g/m$^2$. Thereby, smuts mainly including aluminum hydroxide which had occurred during the electrochemical surface roughening by using the alternate current were removed, and the edge portions of pits generated were dissolved and smoothened. The aluminum plate was then washed with water.

(e) The aluminum plate was desmutted by spraying an aqueous solution including 25 mass % of sulfuric acid and 0.5 mass % of aluminium ions and kept at 60°C to the plate. Water was sprayed on the plate to wash the plate.

(f) The aluminum plate was anodized in an electrolyte containing sulfuric acid at a concentration 170 g/L and additionally containing aluminium ions at a concentration 0.5 mass % and kept at 33°C at an electric current density of 5 A/dm$^2$ for 50 seconds. The aluminum plate was then washed with water. After the treatment, the amount of anodic oxide film was 2.7 g/m$^2$.

An aluminum support was thus obtained. The surface roughness Ra of the aluminum support was measured with an apparatus, SURFCOM manufactured by Tokyo Seimitsu Co. Ltd., and having a stylus with a distal diameter of 2 μm, and found to be 0.27.

<Undercoat layer>

Subsequently, the following coating solution for an undercoat layer was applied onto the aluminum support with a wire bar and the resultant coating was dried at 90°C for 30 seconds. The coating amount was 10 mg/$m^2$.

Coating solution for undercoat layer

- Polymer compound A having the following structure 0.05 g
- Methanol 27 g
- Deionized water 3 g

Polymer compound A

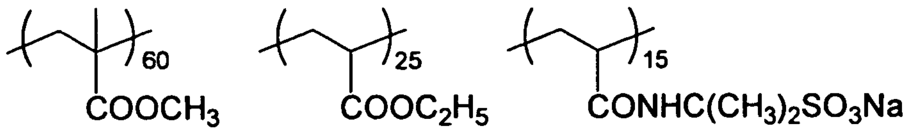

Photosensitive layer

Subsequently, the following photosensitive layer coating solution [P-1] was prepared and applied onto the undercoat layer with a wire bar. The coated support was dried with a hot-air dryer at 115°C for 34 seconds. The dry coating amount was 1.3 g/$m^2$.

<Photosensitive layer coating solution [P-1]>

- Infrared absorbent (IR-1) 0.074 g
- Polymerization initiator (OS-12) 0.280 g
- Additive (PM-1) 0.151 g
- Polymerizable compound (AM-1) 1.00 g
- Binder polymer (BT-1) 1.00 g
- Ethyl violet (C-1) 0.04 g
- Fluorinated surfactant 0.015 g
  (MEGAFAC F-780-F manufactured by Dainippon Ink and Chemicals, Inc. in the form of a 30 mass % methyl isobutyl ketone (MIBK) solution)
- Methyl ethyl ketone 10.4 g
- Methanol 4.83 g
- 1-Methoxy-2-propanol 10.4 g

The polymerization initiator (OS-12) used in the photosensitive layer coating solution is one of the aforementioned onium salt compounds represented by Formula (1). The structures of the infrared absorbent (IR-1), additive (PM-1), polymerizable compound (AM-1), binder polymer (BT-1), and ethyl violet (C-1) are shown below.

(IR-1)

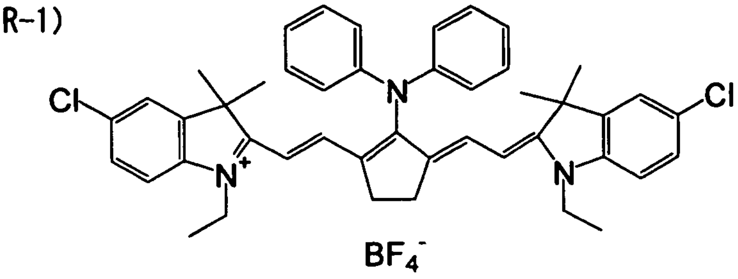

(PM-1)

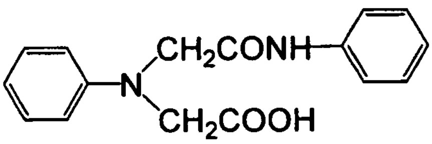

(AM-1)

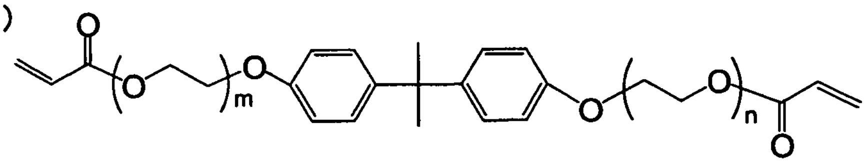

m+n≒4

(BT-1)

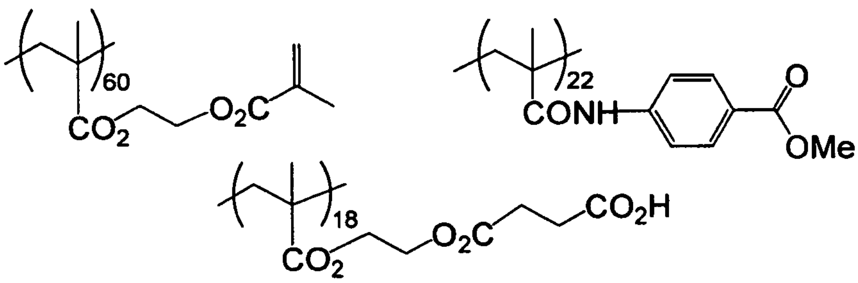

(C-1)

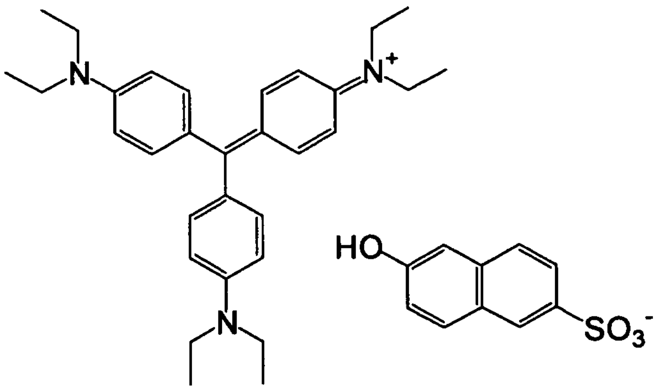

[Protective layer (overcoat layer)]

An aqueous solution containing polyvinyl alcohol (degree of saponification of 98 mol %, degree of polymerization of 500) and polyvinylpyrrolidone (LUVISKOL K-30 manufacture by BASF) was applied onto the photosensitive layer with a wire bar and the coating was dried with a hot-air dryer at 125°C for 75 seconds. The ratio of polyvinyl alcohol to polyvinylpyrrolidone was 4/ 1 mass %, and the dry coating amount was 2.30 g/m$^2$. Thus, a planographic printing plate precursor was prepared.

[Evaluation]

(1) Evaluation of sensitivity

The planographic printing plate precursor obtained was exposed to light at a resolution of 2400 dpi at an external surface drum revolution of 150 rpm by using TREND SETTER 3244 manufactured by Creo Co., Ltd. while output was stepwise changed in the range of 0 to 8 W and log E was changed at an interval of 0.15. The exposure was carried out at 25°C at 50% RH. The exposed planographic printing plate was developed with an automatic developing machine LP-1310HII manufactured by Fuji Photo Film Co., Ltd., at a traveling speed (line speed) of 2 m/minute and a developing temperature of 30°C. Before the development, heating and washing treatments were not conducted. The developing solution had the following composition, and the finisher was a solution in which liquid GN-2K manufactured by Fuji Photo Film Co., Ltd. had been diluted with water at a ratio of 1:1.

The density of the image portions of the developed planographic printing plate, the cyan density, was measured with a Macbeth reflection densitometer RD-918 and the red filter attached to the densitometer. The inverse of light exposure necessary to obtain a measured density of 0.8 was used as an indicator of sensitivity. Evaluation results of the planographic printing plates are represented by relative values, given the sensitivity of the planographic printing plate of Example 1 was regarded as 100. The larger the value is, the higher the sensitivity is. Results are summarized in Table 1.

Developing solution

The following components was dissolved in water and potassium hydroxide was added to the resultant solution to adjust the pH of the solution to 11.95 at 25°C. Thus, a developing solution was obtained.

- Monoalcohol or monoketone compound
  The type and amount of the compound are shown in Table 1.
- Surfactant (K-1) 4.00 % by mass
- Tetrasodium ethylenediamine tetraacetate 0.16% by mass
- Potassium carbonate 0.16% by mass

(2) Evaluation of image quality

The planographic printing plate precursor obtained was exposed to light with TREND SETTER 3244 manufactured by Creo Co., Ltd. at a resolution of 2,400 dpi at an output of 7W at an external surface drum revolution of 150 rpm

at a plate-surface energy of 110 mJ/cm$^2$. At this time, an 80% screen tint image was used. The exposed plate was developed in the same manner as the development in the sensitivity evaluation. The degree of screen-tint unevenness on the developed planographic printing plate was visually checked. The results were classified into levels 1 to 5, and level 3 represents the practically allowable lower limit and levels 2 and 1 are not at practical level.

(3) Evaluation of printing properties

The planographic printing plate used in the evaluation of image quality (2) was set in a printing machine LITHRONE manufactured by Komori Corp., and printing was conducted. The degree of stain in the non-image portions and printing durability were evaluated. The degree of stain in the non-image portions was sensorily classified into levels 1 to 5, and level 3 is the practically lower-limit allowable level and levels 2 and 1 are not at practical level.

(4) Evaluation of continuous printing stability

Planographic printing plates exposed in the same manner as the exposure in the evaluation of image quality (2) were developed. At this time, the total length of the developed plates was 3,000 m$^2$ with respect to 45 liters of the developing solution. Planographic printing plates exposed in the same manner as the exposure in the evaluation of image quality (2) were developed with the fatigued developing solution. The sensitivity (1), image quality (2), and printing properties (3) of the latter plates were evaluated. The evaluation results obtained were compared with those obtained by using an initial developing solution, and used as an indicator of continuous processing stability.

(5) Evaluation of developer tank's stain

Planographic printing plates exposed in the same manner as the exposure in the evaluation of image quality (2) were developed until the total length of the developed plates was 3,000 m$^2$ with respect to 45 liters of the developing solution. The fatigued developing solution was discharged from the machine, and the degree of stain on the developer tank caused by generation of gel was visually checked. Check results were sensorily classified to levels 1 to 5, and level 3 is the practically allowable lower limit level and levels 2 and 1 are not at practical level.

These results are summarized in Table 1.

Table 1

| | Monoalcohol or monoketone compound | | Initial developing solution | | | | Fatigued developing solution | | | | Stain on developer tank |
|---|---|---|---|---|---|---|---|---|---|---|---|
| | | | Sensitivity | Image quality | Printing properties | | Sensitivity | Image quality | Printing properties | | |
| | Compound used | Addition amount | | | Stain in non-image portion | Printing durability | | | Stain in non-image portion | Printing durability | |
| Example 1 | Cyclohexanol | 2 mass % | 100 | 4 | 4 | 150,000 sheets | 100 | 4 | 4 | 150,000 sheets | 4 |
| Example 2 | Cyclohexanol | 4 mass % | 100 | 5 | 5 | 150,000 sheets | 100 | 5 | 5 | 150,000 sheets | 5 |
| Example 3 | Cyclohexanol | 8 mass % | 95 | 5 | 5 | 130,000 sheets | 95 | 5 | 5 | 130,000 sheets | 5 |
| Example 4 | Cyclohexanone | 2 mass % | 100 | 5 | 4 | 150,000 sheets | 100 | 5 | 4 | 150,000 sheets | 4 |
| Example 5 | Cyclohexanone | 4 mass % | 100 | 5 | 5 | 150,000 sheets | 100 | 5 | 5 | 150,000 sheets | 4 |
| Example 6 | Cyclohexanone | 8 mass % | 100 | 5 | 5 | 150,000 sheets | 100 | 5 | 5 | 150,000 sheets | 4 |
| Example 7 | Iso-butylalcohol | 2 mass % | 100 | 4 | 4 | 150,000 sheets | 100 | 4 | 4 | 150,000 sheets | 4 |
| Example 8 | Iso-butylalcohol | 4 mass % | 100 | 5 | 5 | 150,000 sheets | 100 | 5 | 5 | 150,000 sheets | 4 |
| Example 9 | Iso-butylalcohol | 8 mass % | 100 | 5 | 5 | 150,000 sheets | 100 | 5 | 5 | 150,000 sheets | 4 |
| Comparative example 1 | - | - | 100 | 1 | 1 | 130,000 sheets | 100 | 1 | 1 | 130,000 sheets | 1 |

As is apparent from Table 1, the planographic printing plates prepared by the method of making a planographic printing plate in Examples 1 to 9, i.e., a method in which development of the plate precursors is conducted with a developing solution containing an antigelling agent (monoalcohol and/or monoketone compound) at a traveling speed of the planographic printing plate of 1.25 m/min or more without heating and washing treatments, were found to be superior in sensitivity, free from unevenness of screen tint images, high in image quality, superior in preventing stains in the non-image portions during printing and superior in printing durability. In addition, the planographic printing plates are also superior in long-term continuous processing stability, since the sensitivity, image quality, stains in the non-image portions during printing, and printing durability when the plates were processed with the fatigued developing solution were similar to those when the plates were processed with the initial developing solution. In addition, gel was not generated in the developing solution even after continuous development for an extended period of time, indicating that stain on the developer tank was prevented.

In contrast, the planographic printing plate developed with a developing solution containing no monoalcohol or monoketone compound in Comparative Example 1 was found to be practically problematic in that the developing property is insufficient, the degree of unevenness of screen tint image is high, image quality is low, and stain in the non-image portion is generated, though the sensitivity and the printing durability are similar to those in Examples 1 to 9. In particular when the fatigued developing solution is used, the sensitivity, image quality, stain in the non-image portions during printing, and printing durability worsen significantly, and long-term continuous processing stability is also low. Further, gel was generated in the developing solution after long-term continuous development, and caused stain on the developer tank, which is practically problematic.

Accordingly, the use of the present invention provides a plate-making method using a planographic printing plate precursor having a protective layer on a photosensitive layer on which an image can be formed with an infrared laser, which plate-making method provides a planographic printing plate having superior image quality and printing durability without generation of stains in the non-image portions even after continuous development for an extended period of time.

## Claims

**1.** The use of a monoalcohol or a monoketone compound as an antigelling agent in a method of making a planographic printing plate, comprising:

exposing to light having a wavelength of 750 to 1,400 nm a planographic printing plate precursor having on a support a photosensitive layer comprising an infrared absorbent, a polymerization initiator, a polymerizable compound, and a binder polymer, and a protective layer in that order; and developing a planographic printing plate exposed in a developing solution substantially without heating and washing, wherein
the developing solution contains, as an antigelling agent, the monoalcohol compound or the monoketone compound.

**2.** The use according to Claim 1, wherein the traveling speed of the planographic printing plate during the development is 1.25 m/min or more.

**3.** The use according to Claim 1, wherein the monoalcohol is at least one compound selected from the group consisting of n-propyl alcohol, iso-propyl alcohol, n-butyl alcohol, iso-butyl alcohol, sec-butyl alcohol, t-butyl alcohol, n-amyl alcohol, sec-amyl alcohol, t-amyl alcohol, cyclohexanol and derivatives thereof, phenoxyethanol and derivatives thereof, and phenol and derivatives thereof.

**4.** The use according to Claim 1, wherein the monoketone is at least one compound selected from the group consisting of diethyl ketone, and cyclohexanone and derivatives thereof.

**5.** The use according to Claim 1, wherein the photosensitive layer further contains a coloring agent.

**6.** The use according to Claim 5, wherein the coloring agent is a cationic dye.

**7.** The use according to Claim 1, wherein the infrared absorbent has an absorption maximum at a wavelength of 750 to 1,400 nm.

**8.** The use according to Claim 6, wherein the coloring agent is a cyanine dye.

9. The use according to Claim 1, wherein the infrared absorbent is a pigment having an absorption maximum at a wavelength of 750 to 1,400 nm.

10. The use according to Claim 9, wherein the pigment is carbon black.

11. The use according to Claim 9, wherein the pigment is particles having a diameter of 0.1 to 1 μm.

12. The use according to Claim 1, wherein the infrared absorbent is contained in an amount of 0.1 to 10% by mass with respect to the total solid matter in the photosensitive layer.

13. The use according to Claim 1, wherein the polymerization initiator is an onium salt.

14. The use according to Claim 1, wherein the polymerization initiator has a maximum absorption wavelength at 360 nm or less.

15. The use according to Claim 1, wherein the total amount of the polymerization initiator is 1 to 20% by mass with respect to the total solid matter in the photosensitive layer.

16. The use according to Claim 1, wherein the polymerizable compound is an addition-polymerizable compound having at least one ethylenic unsaturated double bond.

17. The use according to Claim 1, wherein the total amount of the binder polymer is 30 to 70% by weight with respect to the total weight of nonvolatile components in the photosensitive layer composition.

18. The use according to Claim 1, wherein the dry coating amount of the photosensitive layer is 0.5 to 5 $g/m^2$.

19. The use according to Claim 1, wherein the protective layer contains polyvinyl alcohol and polyvinylpyrrolidone.

## Patentansprüche

1. Verwendung einer Monoalkohol- oder einer Monoketonverbindung als Gelierungsverhinderungsmittel in einem Verfahren zur Erstellung einer Planographie-Druckplatte umfassend:

   Belichten eines Planographie-Druckplattenvorläufers, der auf einem Träger eine fotoempfindliche Schicht, die einen Infrarotabsorber, einen Polymerisationsstarter, eine polymerisierbare Verbindung und ein Bindemittelpolymer umfaßt, und eine Schutzschicht in dieser Reihenfolge aufweist, mit Licht einer Wellenlänge von 750 bis 1.400 nm und Entwickeln der belichteten Planographie-Druckplatte in einer Entwicklerlösung im wesentlichen ohne Erwärmen und Waschen, wobei
   die Entwicklerlösung die Monoalkoholverbindung oder die Monoketonverbindung als ein Gelierungsverhinderungsmittel enthält.

2. Verwendung gemäß Anspruch 1, wobei die Durchlaufgeschwindigkeit der Planographie-Druckplatte während des Entwickelns 1,25 m/min oder mehr beträgt.

3. Verwendung gemäß Anspruch 1, wobei der Monoalkohol wenigstens eine Verbindung ausgewählt aus der Gruppe bestehend aus n-Propylalkohol, Isopropylalkohol, n-Butylalkohol, Isobutylalkohol, sec-Butylalkohol, t-Butylalkohol, n-Amylalkohol, sec-Amylalkohol, t-Amylalkohol, Cyclohexanol und Derivaten davon, Phenoxyethanol und Derivaten davon und Phenol und Derivaten davon ist.

4. Verwendung gemäß Anspruch 1, wobei das Monoketon wenigstens eine Verbindung ausgewählt aus der Gruppe bestehend aus Diethylketon und Cyclohexanon und Derivaten davon ist.

5. Verwendung gemäß Anspruch 1, wobei die fotoempfindliche Schicht ferner ein färbendes Mittel enthält.

6. Verwendung gemäß Anspruch 5, wobei das färbende Mittel ein kationischer Farbstoff ist.

7. Verwendung gemäß Anspruch 1, wobei der Infrarotabsorber ein Absorptionsmaximum bei einer Wellenlänge von

750 bis 1.400 nm aufweist.

**8.** Verwendung gemäß Anspruch 6, wobei das färbende Mittel ein Cyaninfarbstoff ist.

**9.** Verwendung gemäß Anspruch 1, wobei der Infrarotabsorber ein Pigment mit einem Absorptionsmaximum bei einer Wellenlänge von 750 bis 1.400 nm ist.

**10.** Verwendung gemäß Anspruch 9, wobei das Pigment Ruß ist.

**11.** Verwendung gemäß Anspruch 9, wobei das Pigment Teilchen mit einem Durchmesser von 0,1 bis 1 μm ist.

**12.** Verwendung gemäß Anspruch 1, wobei der Infrarotabsorber in einer Menge von 0,1 bis 10 Massen%, bezogen auf den Gesamtfeststoff in der fotoempfindlichen Schicht, enthalten ist.

**13.** Verwendung gemäß Anspruch 1, wobei der Polymerisationsstarter ein Oniumsalz ist.

**14.** Verwendung gemäß Anspruch 1, wobei der Polymerisationsstarter eine maximale Absorptionswellenlänge bei 360 nm oder weniger aufweist.

**15.** Verwendung gemäß Anspruch 1, wobei die Gesamtmenge des Polymerisationsstarters 1 bis 20 Massen%, %, bezogen auf den Gesamtfeststoff in der fotoempfindlichen Schicht, beträgt.

**16.** Verwendung gemäß Anspruch 1, wobei die polymerisierbare Verbindung eine Additions-polymerisierbare Verbindung mit wenigstens einer ethylenisch ungesättigten Doppelbindung ist.

**17.** Verwendung gemäß Anspruch 1, wobei die Gesamtmenge des Bindemittelpolymers 30 bis 70 Gew.%, %, bezogen auf das Gesamtgewicht der nicht-flüchtigen Komponenten in der Zusammensetzung der fotoempfindlichen Schicht, beträgt.

**18.** Verwendung gemäß Anspruch 1, wobei die Trockenbeschichtungsmenge der fotoempfindlichen Schicht 0,5 bis 5 $g/m^2$ beträgt.

**19.** Verwendung gemäß Anspruch 1, wobei die Schutzschicht Polyvinylalkohol und Polyvinylpyrrolidon enthält.

## Revendications

**1.** Utilisation d'un composé monoalcool ou monocétone comme agent anti-gélification dans un procédé de préparation d'une plaque d'impression planographique, comprenant :

l'exposition à une lumière ayant une longueur d'onde allant de 750 à 1400 nm, d'un précurseur de plaque d'impression planographique ayant sur un support, une couche photosensible comprenant un absorbant infrarouge, un initiateur de polymérisation, un composé polymérisable et un polymère liant, et une couche protectrice, en cet ordre ; et le développement d'une plaque d'impression planographique exposée, dans une solution de développement, sensiblement sans chauffage et lavage, où
la solution de développement contient, comme agent anti-gélification, le composé monoalcool ou le composé monocétone.

**2.** Utilisation selon la revendication 1, dans laquelle la vitesse de déplacement de la plaque d'impression planographique pendant le développement est de 1,25 m/minute ou plus.

**3.** Utilisation selon la revendication 1, dans laquelle le monoalcool est au moins un composé choisi parmi le groupe consistant en le n-propylalcool, l'isopropylalcool, le n-butylalcool, l'isobutylalcool, le s-butylalcool, le t-butylalcool, le n-amylalcool, le s-amylalcool, le t-amylalcool, le cyclohexanol et leurs dérivés, le phénoxyéthanol et ses dérivés, et le phénol et ses dérivés.

**4.** Utilisation selon la revendication 1, dans laquelle la monocétone est au moins un composé choisi parmi le groupe consistant en la diéthylcétone et la cyclohexanone et leurs dérivés.

5. Utilisation selon la revendication 1, dans laquelle la couche photosensible contient de plus, un agent colorant.

6. Utilisation selon la revendication 5, dans laquelle l'agent colorant est un colorant cationique.

7. Utilisation selon la revendication 1, dans laquelle l'absorbant infrarouge a un maximum d'absorption à une longueur d'onde allant de 750 à 1400 nm.

8. Utilisation selon la revendication 6, dans laquelle l'agent colorant est un colorant cyanine.

9. Utilisation selon la revendication 1, dans laquelle l'absorbant infrarouge est un pigment ayant un maximum d'absorption à une longueur d'onde allant de 750 à 1400 nm.

10. Utilisation selon la revendication 9, dans laquelle le pigment est le noir de carbone.

11. Utilisation selon la revendication 9, dans laquelle le pigment consiste en des particules ayant un diamètre allant de 0,1 à 1 μm.

12. Utilisation selon la revendication 1, dans laquelle l'absorbant infrarouge est présent en une quantité allant de 0,1 à 10% en masse, par rapport à la matière solide totale dans la couche photosensible.

13. Utilisation selon la revendication 1, dans laquelle l'initiateur de polymérisation est un sel d'onium.

14. Utilisation selon la revendication 1, dans laquelle l'initiateur de polymérisation a une longueur d'onde d'absorption maximale à 360 nm ou moins.

15. Utilisation selon la revendication 1, dans laquelle la quantité totale de l'initiateur de polymérisation se situe dans l'intervalle allant de 1 à 20% en masse, par rapport à la matière solide totale de la couche photosensible.

16. Utilisation selon la revendication 1, dans laquelle le composé polymérisable est un composé polymérisable par addition ayant au moins une double liaison éthyléniquement insaturée.

17. Utilisation selon la revendication 1, dans laquelle la quantité totale du polymère liant se situe dans l'intervalle allant de 30 à 70% en poids, par rapport au poids total des composants non volatils dans la composition de la couche photosensible.

18. Utilisation selon la revendication 1, dans laquelle la quantité de revêtement sec de la couche photosensible se situe dans l'intervalle allant de 0,5 à 5 $g/m^2$.

19. Utilisation selon la revendication 1, dans laquelle la couche protectrice contient un poly(alcool vinylique) et une polyvinylpyrrolidone.

FIG.1

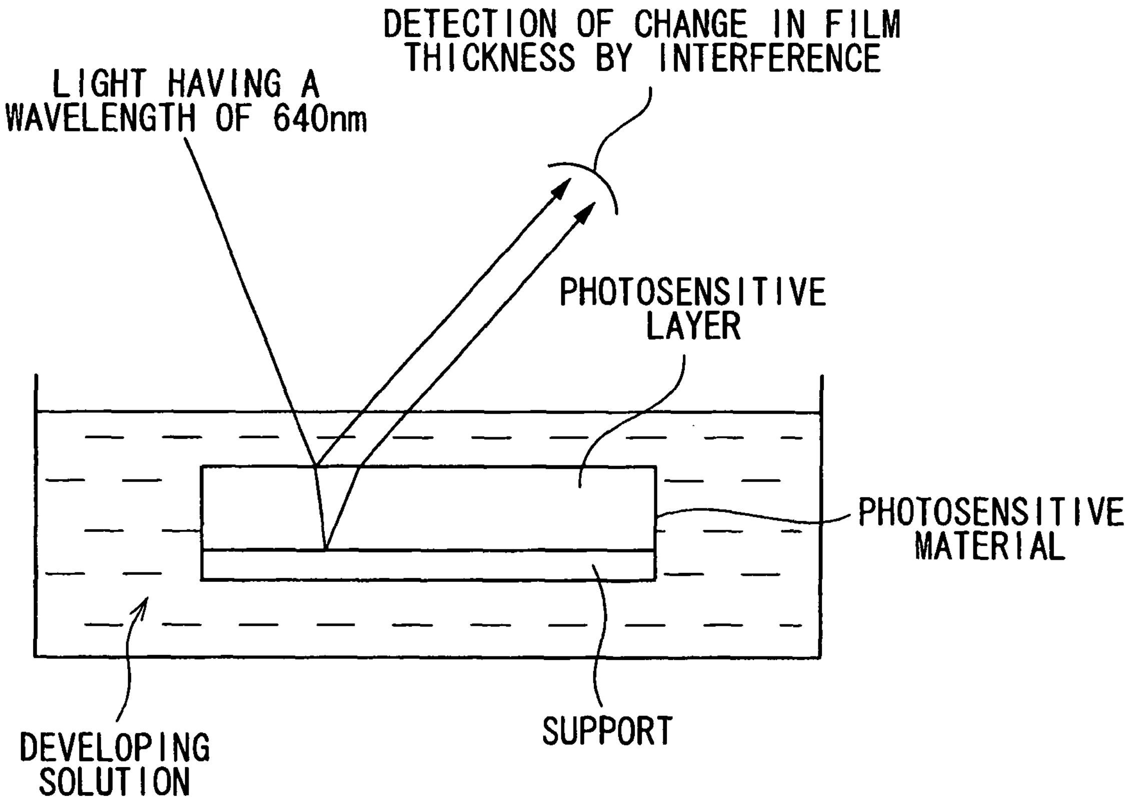
DETECTION OF CHANGE IN FILM THICKNESS BY INTERFERENCE
LIGHT HAVING A WAVELENGTH OF 640nm
PHOTOSENSITIVE LAYER
PHOTOSENSITIVE MATERIAL
DEVELOPING SOLUTION
SUPPORT

FIG.2

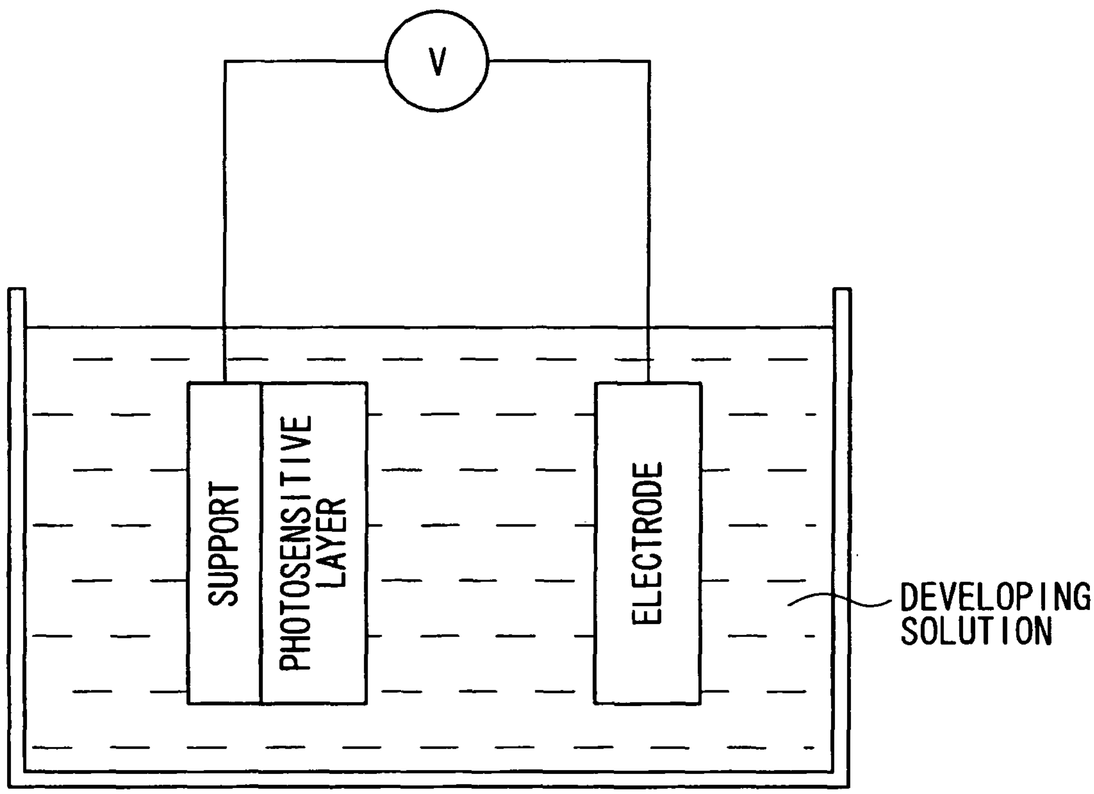
V
SUPPORT
PHOTOSENSITIVE LAYER
ELECTRODE
DEVELOPING SOLUTION

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 59044615 A
- JP 54034327 B
- JP 58012577 B
- JP 54025957 B
- JP 54092723 A
- JP 59053836 A
- JP 59071048 A
- JP 2002040652 A
- JP 58125246 A
- JP 59084356 A
- JP 60078787 A
- JP 58173696 A
- JP 58181690 A
- JP 58194595 A
- JP 58112793 A
- JP 58224793 A
- JP 59048187 A
- JP 59073996 A
- JP 60052940 A
- JP 60063744 A
- JP 58112792 A
- GB 434875 A
- US 5156938 A
- US 3881924 A
- JP 57142645 A
- US 4327169 A
- JP 58181051 A
- JP 58220143 A
- JP 59041363 A
- JP 59084248 A
- JP 59084249 A
- JP 59146063 A
- JP 59146061 A
- JP 59216146 A
- US 4283475 A
- JP 5013514 B
- JP 5019702 B
- US 4756993 A
- JP 2001006326 A
- JP 2001237840 A
- JP 2001133969 A
- JP 2002148790 A
- JP 2002350207 A
- JP 2002006482 A
- JP 2001133696 A
- JP 46027926 B
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 48018327 B
- JP 56028893 A
- JP 53012739 A
- JP 48028123 B
- US 3658662 A
- JP 46027481 B
- JP 52058602 A
- JP 52030503 A
- JP 50007481 B
- JP 54072104 A
- JP 59101651 A
- JP 60149491 A
- JP 60232998 A
- JP 3056177 A
- JP 4282637 A
- JP 5016558 A
- JP 5246171 A
- JP 7159983 A
- JP 7314937 A
- JP 8202025 A
- JP 8320551 A
- JP 9034104 A
- JP 9236911 A
- JP 9269593 A
- JP 10069092 A
- JP 10115931 A

- JP 10161317 A
- JP 10260536 A
- JP 10282682 A
- JP 11084674 A
- JP 8225335 A
- JP 8270098 A
- JP 9195863 A
- JP 9195864 A
- JP 9089646 A
- JP 9106068 A
- JP 9183834 A
- JP 9264311 A
- JP 9127232 A
- JP 9245419 A
- JP 10127602 A
- JP 10170202 A
- JP 11036377 A
- JP 11165861 A
- JP 11284091 A
- JP 2000014697 A
- US 3458311 A
- JP 55049729 B
- US 4882246 A
- JP 50026601 A
- JP 58054341 A
- JP 56039464 B
- JP 56042860 B
- JP 57007427 B
- JP 54008002 A
- JP 55115045 A
- JP 59058431 A

**Non-patent literature cited in the description**

- Color Index (C.I.) Handbook. Pigment Handbook. 1977
- Latest Pigment Application Technologies. CMC Publishing, 1986
- Printing Ink technologies. CMC Publishing, 1984
- Properties and Applications of Metal Soaps. Saiwai Shobo
- *J. Adhesion Soc. Jpn,* 1984, vol. 20 (7), 300-308
- Polymer Data Handbook -Basic. Baihukan, 1986